# EUROPEAN PATENT APPLICATION

(11) **EP 4 760 835 A1**
(43) Date of publication of application: **17.06.2026**
(21) Application number: 24890224.9
(22) Date of filing: 13.08.2024
(51) Int. Cl.: H01M 10/04

(54) **CODE-SCANNING-BASED BATTERY CELL REPLACEMENT SYSTEM, CONTROL METHOD AND BATTERY PRODUCTION LINE**

(30) Priority: 17.11.2023 CN 202311536012
(71) Applicant: Contemporary Amperex Technology Co., Limited, Ningde, Fujian 352100 (CN)
(72) Inventor: MA, Yuhang, Ningde, Fujian 352100 (CN); LUO, Jian, Ningde, Fujian 352100 (CN); JING, Zhiyong, Ningde, Fujian 352100 (CN)
(74) Representative: Lorenz Seidler Gossel Part. mbB
(86) International application number: PCT/CN2024/111691
(87) International publication number: WO 2025/102861

(57) **Abstract**

This disclosure discloses a cell scanning and replacement system, a control method thereof, and a battery production line, relating to the field of battery technology. The cell scanning and replacement system can improve the production efficiency of cells. The cell scanning and replacement system includes: a testing device, an identification device, and a replacement device, where the testing device includes a testing mechanism, and the testing mechanism is configured to test a cell; the identification device is connected to the testing device, and the identification device is configured to acquire identification information of the cell, where the identification information is associated with a test result of the cell; and the replacement device is connected to the testing device, the replacement device includes a replacement mechanism, the replacement mechanism is electrically connected to the identification device, and the replacement mechanism is configured to replace a cell to be replaced based on the identification information.

## Description

### CROSS-REFERENCE TO RELATED APPLICATIONS

This disclosure is based on and claims priority to Chinese Patent Application No. 202311536012.1, filed on November 17, 2023 and entitled "CELL SCANNING AND REPLACEMENT SYSTEM, CONTROL METHOD THEREOF, AND BATTERY PRODUCTION LINE", which is incorporated herein by reference in its entirety.

### TECHNICAL FIELD

This disclosure relates to the field of battery technology, and in particular, to a cell scanning and replacement system, a control method thereof, and a battery production line.

### BACKGROUND

Batteries are increasingly widely used in daily life and industrial applications. For example, new energy vehicles equipped with batteries have been widely used. Batteries are also increasingly applied in fields such as energy storage.

During the battery production process, it is necessary to test individual battery cells to ensure that each produced battery cell meets usage requirements. In the process of testing battery cells, there will inevitably be defective battery cells. It is necessary to promptly replace defective battery cells to reduce the risk of quality issues in battery modules composed of battery cells. In related technologies, the replacement of defective battery cells is typically performed manually, which affects battery production efficiency.

### SUMMARY

This disclosure provides a cell scanning and replacement system, a control method thereof, and a battery production line, so as to improve production efficiency of cells.

A first aspect of this disclosure provides a cell scanning and replacement system, where the cell scanning and replacement system includes: a testing device, an identification device, and a replacement device, where the testing device includes a testing mechanism, and the testing mechanism is configured to test a cell; the identification device is connected to the testing device, and the identification device is configured to acquire identification information of the cell, where the identification information is associated with a test result of the cell; and the replacement device is connected to the testing device, the replacement device includes a replacement mechanism, the replacement mechanism is electrically connected to the identification device, and the replacement mechanism is configured to replace a cell to be replaced based on the identification information.

The cell scanning and replacement system according to this disclosure, with the testing device including the testing mechanism, can test a cell through the testing mechanism, thereby improving the cell testing efficiency. Additionally, with the identification device connected to the testing device, identification information of the cell can be acquired through the identification device, allowing the identification information of the cell to be bound with test result data of the cell, thereby establishing a relationship between the identification information and test result of the cell. Production data, process data, and the like of the cell can also be bound with the identification information of the cell, facilitating traceability of various data generated during the cell production process. Furthermore, the replacement device connected to the testing device is also provided, and the replacement mechanism in the replacement device is electrically connected to the identification device, allowing the replacement mechanism to be controlled based on the identification information associated with the test result to quickly and accurately replace unqualified cells to be replaced, thereby improving the cell production efficiency.

In a possible implementation of this disclosure, the testing device further includes a testing bracket and a testing longitudinal drive mechanism, where the testing longitudinal drive mechanism is movably disposed on the testing bracket along a first direction, the testing mechanism and the identification device are both mounted on the testing longitudinal drive mechanism; and under the drive of the testing longitudinal drive mechanism, the testing mechanism and the identification device are both capable of moving along the first direction.

In this technical solution, since the testing bracket is provided in the testing device, other components can be mounted on and supported by the testing bracket, and the testing device can be installed at a testing station through the testing bracket. Additionally, the testing longitudinal drive mechanism is movably disposed on the testing bracket, and the testing mechanism, the identification device, and the like can be mounted on the testing longitudinal drive mechanism, allowing the testing longitudinal drive mechanism to drive the testing mechanism, the identification device, and the like to move along the first direction, thereby testing the cells located at different positions.

In a possible implementation of this disclosure, the identification device includes an identification component and an identification vertical drive component, where the identification component is mounted on the identification vertical drive component and is configured to acquire the identification information; and the identification vertical drive component is mounted on the testing longitudinal drive mechanism, and the identification vertical drive component is configured to drive the identification component to move along a third direction toward or away from the cell, the third direction forming an angle with the first direction.

In this technical solution, since the identification component is provided in the identification device, the identification component can identify an identification marker on the cell, thereby acquiring the identification information of the cell. Additionally, the identification vertical drive component is also provided in the identification device and the identification component is mounted on the identification vertical drive component, allowing the identification vertical drive component to drive the identification component to move along the third direction, thereby adjusting the distance between the identification component and the cell. This enables the identification component to quickly and accurately acquire identification markers on cells of various sizes, improving the applicability and identification efficiency of the identification device.

In a possible implementation of this disclosure, the testing mechanism includes a testing component and a testing vertical drive component, where the testing component is mounted on the testing vertical drive component and is configured to test a cell; and the testing vertical drive component is mounted on the testing longitudinal drive mechanism, and the testing vertical drive component is configured to drive the testing component to move along the third direction toward or away from the cell, bringing the testing component into contact with or separation from the cell, the third direction forming an angle with the first direction.

In this technical solution, since the testing component is provided in the testing mechanism, the testing component can perform corresponding test items on the cell. Additionally, the testing vertical drive component is provided in the testing mechanism and the testing component is mounted on the testing vertical drive component, so that the testing vertical drive component can drive the testing component to move along the third direction, bringing the testing component into contact with or separation from cells of different sizes and specifications, thereby improving the applicability of the testing mechanism.

In a possible implementation of this disclosure, the testing vertical drive component includes a vertical power component, a vertical assistance component, and a vertical guide component, where the vertical guide component has one end mounted on the testing longitudinal drive mechanism and another end connected to the testing component, and is configured to guide the testing component to move along the third direction; the vertical power component has one end connected to the testing longitudinal drive mechanism and another end connected to the testing component, and is configured to drive the testing component to move along the third direction; and the vertical assistance component has one end connected to the testing longitudinal drive mechanism and another end connected to the testing component, and under the action of the vertical assistance component, the testing component has a tendency to move along the third direction toward the testing longitudinal drive mechanism.

In this technical solution, since the vertical guide component is provided in the testing vertical drive component, the vertical guide component can restrict the movement direction of the testing component with respect to the testing longitudinal drive mechanism to the third direction. Additionally, the vertical power component is provided between the testing component and the testing longitudinal drive mechanism, and the vertical power component can provide driving force for the testing component, driving the testing component to move along the third direction. Furthermore, the vertical assistance component is provided between the testing component and the testing longitudinal drive mechanism, and the vertical assistance component can reduce the magnitude of the driving force required to be provided by the vertical power component to the testing component, thereby reducing the load on the vertical power component and extending the service life of the vertical power component.

In a possible implementation of this disclosure, the testing mechanism further includes a testing transverse drive component, where one end of the testing transverse drive component is mounted on the testing vertical drive component, the testing component is connected to the testing transverse drive component, and the testing transverse drive component is configured to drive the testing component to move along a second direction, the second direction forming an angle with each of the first direction and the third direction.

In this technical solution, since the testing transverse drive component is provided in the testing mechanism and the testing component is mounted on the testing transverse drive component, the testing transverse drive component can drive the testing component to move along the second direction. This allows for adjustment of the position of the testing component with respect to the cell in the second direction, leaving the testing component at a position opposite the cell in the second direction.

In a possible implementation of this disclosure, the testing mechanism further includes a testing longitudinal drive component, and the testing component includes a first testing piece and a second testing piece, where the first testing piece is fixedly disposed on the testing transverse drive component; the second testing piece is slidably disposed on the testing transverse drive component; and the testing longitudinal drive component has one end connected to the testing transverse drive component and another end connected to the second testing piece, and the testing longitudinal drive component is configured to drive the second testing piece to move along the first direction toward or away from the first testing piece.

In this technical solution, since the testing component is arranged as a structure including the first testing piece and the second testing piece, and the second testing piece is slidably disposed on the testing transverse drive component along the first direction, the second testing piece can move along the first direction. Additionally, the testing longitudinal drive component is provided between the testing transverse drive component and the second testing piece, and the testing longitudinal drive component can drive the second testing piece to move along a direction toward or away from the first testing piece, thereby adjusting the spacing between the second testing piece and the first testing piece. This allows the spacing between the second testing piece and the first testing piece to match the spacing between the poles on cells of different sizes and specifications, thereby improving the applicability of the testing mechanism.

In a possible implementation of this disclosure, the testing device further includes a testing lifting mechanism, and the testing lifting mechanism includes a testing lifting bracket, a testing lifting guide component, a testing lifting drive component, and a testing lifting limit component, where the testing lifting guide component has one end connected to the testing bracket and another end connected to the testing lifting bracket, the testing lifting guide component is configured to guide the testing lifting bracket to move along the third direction, and the testing lifting bracket is configured to support a module tray; the testing lifting drive component has one end connected to the testing lifting guide component and another end connected to the testing lifting bracket, and the testing lifting drive component is configured to drive the testing lifting bracket to move along the third direction; and the testing lifting limit component is mounted on the testing bracket and is configured to restrict a position of the module tray with respect to the testing bracket.

In this technical solution, since the testing lifting mechanism is provided in the testing device, the testing lifting mechanism can lift the module tray along the third direction to restrict the position of the module tray in the third direction. Additionally, the testing lifting limit component is provided in the testing lifting mechanism, and the testing lifting limit component can restrict the position of the module tray with respect to the testing bracket along the second direction.

In a possible implementation of this disclosure, the replacement device further includes a replacement bracket and a replacement longitudinal drive mechanism, where the replacement longitudinal drive mechanism is movably disposed on the replacement bracket along the first direction, the replacement mechanism is connected to the replacement longitudinal drive mechanism, and the replacement longitudinal drive mechanism is configured to drive the replacement mechanism to move along the first direction with respect to the replacement bracket.

In this technical solution, since the replacement bracket is provided in the replacement device, other components can be mounted on and supported by the replacement bracket, and the replacement device can be installed through the replacement bracket at a replacement station for replacing cells to be replaced. Additionally, the replacement longitudinal drive mechanism is movably disposed on the replacement bracket, and the replacement mechanism can be mounted on the replacement longitudinal drive mechanism, allowing the replacement longitudinal drive mechanism to drive the replacement mechanism to move along the first direction, thereby replacing cells to be replaced at different positions.

In a possible implementation of this disclosure, the replacement device further includes a replacement transverse drive component, where the replacement transverse drive component is mounted on the replacement longitudinal drive mechanism, the replacement mechanism is connected to the replacement transverse drive component, and the replacement transverse drive component is configured to drive the replacement mechanism to move along the second direction.

In this technical solution, the replacement transverse drive component is provided in the replacement device and the replacement mechanism is connected to the replacement transverse drive component, the replacement transverse drive component can drive the replacement mechanism to move along the second direction, thereby adjusting the position of the replacement mechanism with respect to the spare cell and the cell to be replaced in the second direction. This allows the replacement mechanism at a position opposite the spare cell and the cell to be replaced in the second direction.

In a possible implementation of this disclosure, the replacement device further includes a replacement vertical drive component, where the replacement vertical drive component is mounted on the replacement transverse drive component, the replacement mechanism is mounted on the replacement vertical drive component, and the replacement vertical drive component is configured to drive the replacement mechanism to move along the third direction.

In this technical solution, since the replacement vertical drive component is provided in the replacement device and the replacement mechanism is mounted on the replacement vertical drive component, the replacement vertical drive component can drive the replacement mechanism to move along the third direction, enabling the replacement mechanism to move toward or away from the cell to be replaced or the spare cell along the third direction.

In a possible implementation of this disclosure, the replacement mechanism includes a collection component and a gripper component, where the collection component is configured to acquire identification information of the spare cell; and the gripper component is configured to grasp or release a cell.

In this technical solution, since the collection component is provided in the replacement mechanism, the collection component can collect the identification marker on the spare cell, to obtain the identification information of the spare cell, thereby acquiring the test data and production data of the spare cell. Additionally, the gripper component is provided in the replacement mechanism, and the gripper component can grasp or release the cell to be replaced and the spare cell, thereby removing the cell to be replaced from the module tray and placing the spare cell into the module tray.

In a possible implementation of this disclosure, the replacement device further includes a storage mechanism, the storage mechanism including a storage bracket, a storage tray, and a storage guide component, where the storage bracket is mounted on the replacement bracket; the storage guide component is mounted on the storage bracket and extends along the second direction; and the storage tray is mounted on the storage guide component, and the storage tray is capable of moving along the second direction through the storage guide component.

In this technical solution, since the storage bracket is provided in the storage mechanism, the storage tray can be disposed on the storage bracket. Additionally, the storage guide component is provided between the storage tray and the storage bracket, the storage tray can move along the second direction with respect to the replacement bracket, allowing the storage tray to move to a position far from the replacement mechanism for placing the spare cell on the storage tray, as well as allowing the storage tray to move to a position close to the replacement mechanism.

In a possible implementation of this disclosure, the storage tray includes a positioning piece, a clamping piece, and a clamping drive component, where the positioning piece is mounted on the storage guide component; the clamping drive component has one end connected to the storage guide component and another end connected to the clamping piece, and the clamping drive component is configured to drive the clamping piece to move along a direction toward or away from the positioning piece to clamp or release a cell.

In this technical solution, since the positioning piece and the clamping piece are provided in the storage tray, a storage space can be formed by the positioning piece and the clamping piece to place the cell to be placed at a determined position. Additionally, the clamping piece is mounted on the clamping drive component, the clamping drive component can drive the clamping piece to move, thereby implementing clamping and fixation of cells of different sizes and specifications.

In a possible implementation of this disclosure, the replacement device further includes a replacement lifting mechanism, the replacement lifting mechanism including a replacement lifting bracket, a replacement lifting component, and a release component, where the replacement lifting component has one end connected to the replacement bracket and another end connected to the replacement lifting bracket, the replacement lifting component is configured to drive the replacement lifting bracket to move along the third direction, and the replacement lifting bracket is configured to support the module tray; and the release component is mounted on the replacement lifting bracket and is configured to drive a tray clamping piece on the module tray to move, causing the module tray to release the clamping of a cell.

In this technical solution, since the replacement lifting mechanism is provided in the replacement device, the replacement lifting mechanism can restrict the position of the module tray, so that the module tray stops at a determined position with respect to the replacement mechanism. Additionally, the release component is provided in the replacement lifting mechanism, and the release component can drive the tray clamping piece on the module tray to move, thereby allowing the module tray to release the clamping of the cell, facilitating the grasping of the cell to be replaced by the gripper component in the replacement mechanism.

A second aspect of this disclosure provides a battery production line. The battery production line includes: a cell assembly system, the cell scanning and replacement system according to any one of the above implementations, and a storage system; where the cell assembly system is configured to assemble a cell to obtain the cell to be tested; and the storage system is configured to store a cell that has completed test items.

The battery production line of this disclosure includes the cell scanning and replacement system according to any one of the above implementations, and therefore has the same technical effects, that is, facilitating traceability of various data generated during the cell production process and improving the production efficiency of cells, thereby improving the production efficiency of batteries.

A third aspect of this disclosure provides a control method of a cell scanning and replacement system, where the cell scanning and replacement system includes a host computer, a controller, an identification device, a testing device, and a replacement device, the testing device including a testing mechanism, and the replacement device including a replacement mechanism; and the control method of a cell scanning and replacement system includes: when a cell to be tested reaches a preset position, controlling the identification device to acquire identification information of the cell to be tested, where a plurality of cells to be tested are placed on a cell tray; controlling the testing mechanism to test the cell to be tested to obtain a test result of the cell to be tested; binding the test result of the cell to be tested with the identification information; and controlling, based on the identification information, the replacement mechanism to replace a cell to be replaced.

In this technical solution, the identification device is controlled to acquire the identification information of the cell to be tested, so that the identification information of each cell to be tested on the module tray can be determined, thereby uniquely identifying each cell to be tested through the identification information. Additionally, the testing mechanism is controlled to perform test items on the cell to be tested, so that the test result of the cell to be tested can be obtained. Moreover, the test result of the cell to be tested is bound with the identification information, so that the test data including the test result of each cell can be retrieved through the identification information, facilitating traceability of the cell testing process. Furthermore, based on the identification information of the cell to be tested, the replacement mechanism is controlled to replace the cell to be replaced, improving the accuracy and efficiency of replacing the cell to be replaced, thereby improving the cell production efficiency.

In a possible implementation of this disclosure, the binding the test result of the cell to be tested with the identification information includes:
sending, by the testing mechanism, the test result of the cell to be tested to the controller; and binding, by the controller, the identification information of the cell to be tested with the test result of the cell to be tested, and uploading the bound identification information and test result to the host computer.

In this technical solution, since the controller is electrically connected to the identification device and the testing device, the identification information and the test result of the cell to be tested are bound through the controller, reducing the data transmission paths and the number of transmissions, thereby improving the efficiency of binding the identification information and the test result.

In a possible implementation of this disclosure, the replacement mechanism includes a collection component and a gripper component; and the controlling the replacement mechanism to replace a cell to be replaced includes: controlling, based on identification information of the cell to be replaced, the gripper component to grasp the cell to be replaced; controlling the collection component to collect identification information of a spare cell; and controlling the gripper component to grasp the spare cell and place the spare cell at a replacement position, where the replacement position is a position of the cell to be replaced on the module tray.

In this technical solution, the gripper component is controlled to grasp the cell to be replaced based on the identification information of the cell to be replaced, thereby improving the accuracy and efficiency of grasping the cell to be replaced. Additionally, the collection component is controlled to acquire the identification information of the spare cell, and the identification information of the spare cell can be bound with data such as the test result of the spare cell, facilitating traceability of the test result of the spare cell. Furthermore, the gripper component is controlled to place the spare cell at the replacement position, improving the speed and accuracy of placing the spare cell, thereby improving the efficiency of replacing the cell to be replaced.

In a possible implementation of this disclosure, the controlling the gripper component to grasp the cell to be replaced includes: sending, by the testing mechanism, the test result of the cell to be tested to the controller; in a case that the controller determines that the test result is unqualified, delivering, by the controller, a grasp instruction to the gripper component, where the grasp instruction carries identification information of the cell to be replaced that matches the unqualified test result; and grasping, by the gripper component in response to the grasp instruction, the cell to be replaced that matches the identification information.

In this technical solution, based on the test result of the cell to be tested, the gripper component is controlled to grasp the cell to be replaced, thereby improving the accuracy and efficiency of grasping the cell to be replaced.

In a possible implementation of this disclosure, the controlling the collection component to collect identification information of a spare cell includes: sending, by the collection component, the identification information of the spare cell to the controller; and binding, by the controller, the identification information of the spare cell with a test result of the spare cell, and uploading the bound identification information and test result to the host computer.

In this technical solution, since data such as the identification information and test result of the spare cell is bound through the controller, after the spare cell is placed on the module tray and the plurality of cells on the module tray are assembled into a cell module in subsequent processes, it is convenient to trace data such as the test result of the spare cell through the identification information of the spare cell.

In a possible implementation of this disclosure, the control method of a cell scanning and replacement system further includes: generating a cell dataset of a cell, where the cell dataset includes at least one of the following: identification information of the cell, the test result, process data of the cell, and production data of the cell; generating module identification information of a cell module, where the cell module includes a plurality of cells; and binding the module identification information with the cell datasets of the plurality of cells.

In a possible implementation of this disclosure, the generating module identification information of a cell module includes: generating, by the controller, the module identification information, and sending the module identification information to the host computer; and the binding the module identification information with the cell datasets of the plurality of cells includes: binding, by the host computer, the module identification information with cell datasets of the plurality of cells included in the cell module to obtain bound module identification information, and sending the bound module identification information to the controller; where the controller is capable of controlling, based on the bound module identification information, the cell scanning and replacement system to process the cell module.

In this technical solution, since the cell dataset of the cell is generated based on the identification information, test result, process data, production data, and the like of the cell, the cell dataset of the cell can be acquired through the identification information, facilitating traceability of all data of the cell. Additionally, the module identification information of the cell module including a plurality of cells is generated, and the module identification information is bound with the cell datasets of a plurality of cells, so that the cell datasets of all cells in the cell module can be acquired through the module identification information, facilitating traceability of all data of each cell module.

### BRIEF DESCRIPTION OF DRAWINGS

Various other advantages and benefits will become apparent to those of ordinary skill in the art upon reading the detailed description of the preferred embodiments below. The drawings are only for the purpose of illustrating the preferred embodiments and are not to be considered as limiting this disclosure. Throughout the drawings, the same reference numerals denote the same components. In the drawings:
FIG. 1 is a schematic structural diagram of a battery production line according to this disclosure;
FIG. 2 is a schematic structural diagram of a testing device and an identification device in a cell scanning and replacement system according to this disclosure;
FIG. 3 is a schematic structural diagram of a replacement device in a cell scanning and replacement system according to this disclosure;
FIG. 4 is a first schematic structural diagram of an identification device and a testing mechanism in a testing device according to this disclosure;
FIG. 5 is a second schematic structural diagram of an identification device and a testing mechanism in a testing device according to this disclosure;
FIG. 6 is a schematic structural diagram of a testing lifting mechanism in a testing device according to this disclosure;
FIG. 7 is a schematic structural diagram of a replacement mechanism in a replacement device according to this disclosure;
FIG. 8 is a schematic structural diagram of a storage mechanism in a replacement device according to this disclosure;
FIG. 9 is a schematic structural diagram of a replacement lifting mechanism in a replacement device according to this disclosure;
FIG. 10 is a first schematic flowchart of a control method of a cell scanning and replacement system according to this disclosure;
FIG. 11 is a second schematic flowchart of a control method of a cell scanning and replacement system according to this disclosure;
FIG. 12 is a third schematic flowchart of a control method of a cell scanning and replacement system according to this disclosure; and
FIG. 13 is a fourth schematic flowchart of a control method of a cell scanning and replacement system according to this disclosure.

Description of reference signs:
1. testing device; 11. testing mechanism; 111. testing component; 1111. first testing piece; 1112. second testing piece; 112. testing vertical drive component; 1121. vertical power component; 1122. vertical assistance component; 1123. vertical guide component; 113. testing transverse drive component; 114. testing longitudinal drive component; 1141. adjustment drive piece; 1142. pushing piece; 115. first connecting piece; 12. testing bracket; 13. testing longitudinal drive mechanism; 131. first drive component; 132. first guide component; 133. first bearing bracket; 14. testing lifting mechanism; 141. testing lifting bracket; 142. testing lifting guide component; 143. testing lifting drive component; 144. testing lifting limit component; 2. replacement device; 21. replacement mechanism; 211. collection component; 212. gripper component; 22. replacement bracket; 23. replacement longitudinal drive mechanism; 231. second drive component; 232. second guide component; 233. second bearing bracket; 24. replacement transverse drive component; 25. replacement vertical drive component; 26. storage mechanism; 261. storage bracket; 262. storage tray; 2621. positioning piece; 2622. clamping piece; 2623. clamping drive component; 263. storage guide component; 264. tray bracket; 265. detection grating; 266. indication component; 27. replacement lifting mechanism; 271. replacement lifting bracket; 272. replacement lifting component; 273. release component; 3. identification device; 31. identification component; 32. identification vertical drive component; 4. transfer device; 5. module tray; 6. cell; 7. storage system; A. first direction; B. second direction; and C. third direction.

### DETAILED DESCRIPTION

The following describes in detail the embodiments of technical solutions of this disclosure with reference to the accompanying drawings. The following embodiments are merely used to describe technical solutions of this disclosure more explicitly, and therefore they are merely used as examples and do not constitute any limitations on the protection scope of this disclosure.

Unless otherwise defined, all technical and scientific terms used herein shall have the same meanings as commonly understood by those skilled in the art to which this disclosure relates. The terms used herein are intended to merely describe the specific embodiments rather than to limit this disclosure. The terms "include" and "have" and any other variations thereof in the specification, claims and brief description of drawings of this disclosure are intended to cover non-exclusive inclusions.

In the description of the embodiments of this disclosure, the technical terms "first", "second", "third", and the like are merely intended to distinguish between different objects, and shall not be understood as any indication or implication of relative importance or any implicit indication of the number, sequence or primary-secondary relationship of the technical features indicated. In the description of the embodiments of this disclosure, "a plurality of" means at least two unless otherwise specifically stated.

In this specification, reference to "embodiment" means that specific features, structures or characteristics described with reference to the embodiment may be incorporated in at least one embodiment of this disclosure. The preceding word appearing in various positions in the specification does not necessarily refer to the same embodiment or an independent or alternative embodiment that is exclusive of other embodiments. Persons skilled in the art explicitly and implicitly understand that the embodiments described herein may combine with another embodiment.

In the description of the embodiments of this disclosure, the term "and/or" merely describes an association relationship between associated objects, indicating that three relationships may exist, for example, X and/or Y may indicate: X alone, both X and Y, and Y alone. Additionally, the character "/" herein generally indicates an "or" relationship between the associated objects.

In the description of the embodiments of this disclosure, technical terms such as "length", "width", "thickness", "upper", "lower", "front", "rear", "left", "right", "vertical", "horizontal", "top", "bottom", "inner", "outer", "circumferential", and the like are based on the orientations or positional relationships as shown in the accompanying drawings. These terms are merely for ease and brevity of description of the embodiments of this disclosure rather than indicating or implying that the means or components mentioned must have specific orientations or must be constructed or manipulated according to specific orientations, and therefore shall not be construed as any limitations on the embodiments of this disclosure.

In the description of the embodiments of this disclosure, unless otherwise specified and defined explicitly, the technical terms "mount", "connect", "join", and "fasten" should be understood in their general senses. For example, they may refer to a fixed connection, a detachable connection, or an integral connection, may refer to a mechanical connection or electrical connection, and may refer to a direct connection, an indirect connection via an intermediate medium, or an interaction between two elements. Persons of ordinary skill in the art can understand specific meanings of these terms in the embodiments of this disclosure as appropriate to specific situations.

In the description of the embodiments of this disclosure, unless otherwise explicitly specified and limited, the technical term "contact" should be understood broadly as a direct contact or a contact through an intermediate medium layer, or as a contact between two elements with substantially no interaction force or a contact between two elements with an interaction force.

The following describes this disclosure in detail.

Currently, new energy batteries are increasingly widely used in daily life and industrial applications. New energy batteries are not only applied in energy storage power systems such as hydroelectric, thermal, wind, and solar power stations but are also widely used in electric vehicles such as electric bicycles, electric motorcycles, and electric cars, as well as in aerospace and other fields. With the continuous expansion of the application fields of power batteries, the market demand for power batteries is also continuously increasing.

In the embodiments of this disclosure, a battery may be a battery module or battery pack including a plurality of battery cells (sometimes referred to as cells). A battery cell is a basic unit capable of implementing conversion between chemical energy and electrical energy, and can be used for producing battery modules or battery packs, which in turn are used to supply power to electrical devices. The battery cell may be a secondary battery. The secondary battery is a battery cell that can be recharged after discharge to activate the active material for continued use. The battery cell may be a lithium-ion battery, a sodium-ion battery, a sodium-lithium-ion battery, a lithium metal battery, a sodium metal battery, a lithium-sulfur battery, a magnesium-ion battery, a nickel-hydrogen battery, a nickel-cadmium battery, a lead-acid battery, or the like, which is not limited in the embodiments of this disclosure.

During the production process of cells constituting a battery through a production line, various performance tests can be conducted on the cells using testing equipment to determine whether the performance of the cells meets design requirements. In a case that some defective cells are detected, it is necessary to replace the defective cells. The defective cell can be removed from a cell module, and a qualified spare cell can be placed in the vacant position. In the related art, the replacement of defective cells is performed manually. Such a replacement method has issues such as untimely replacement and incorrect replacement, which affect the testing efficiency of cells and consequently, the production efficiency of batteries.

During the cell testing process, a large amount of test data is generated. For example, tests such as the open circuit voltage (open circuit voltage, OCV) test, internal resistance test, compression test, and capacity test are performed on cells, with each test generating some test data. Additionally, a large amount of production data is generated. For example, the cell passes through a plurality of testing stations, with some production data generated at each testing station. The test data and production data generated during the cell production process can be traced to learn about the production process of the cell and effectively monitor the quality of the cell. Therefore, establishing a traceability method for cells helps improve the quality and efficiency of managing the battery production process.

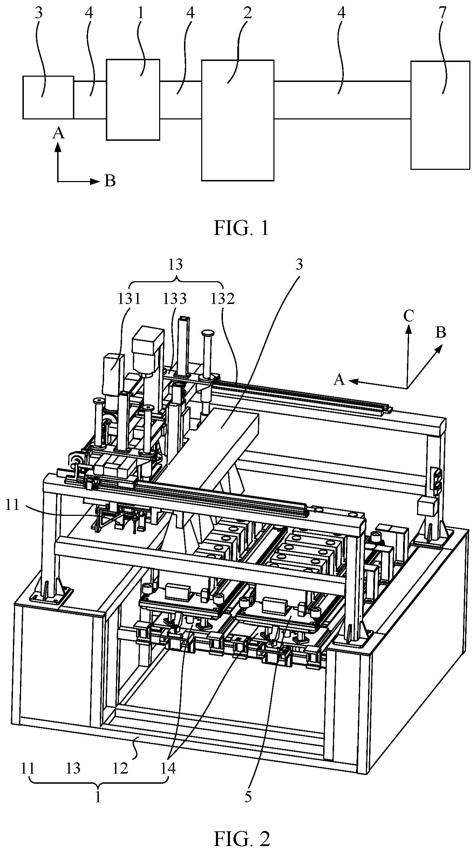

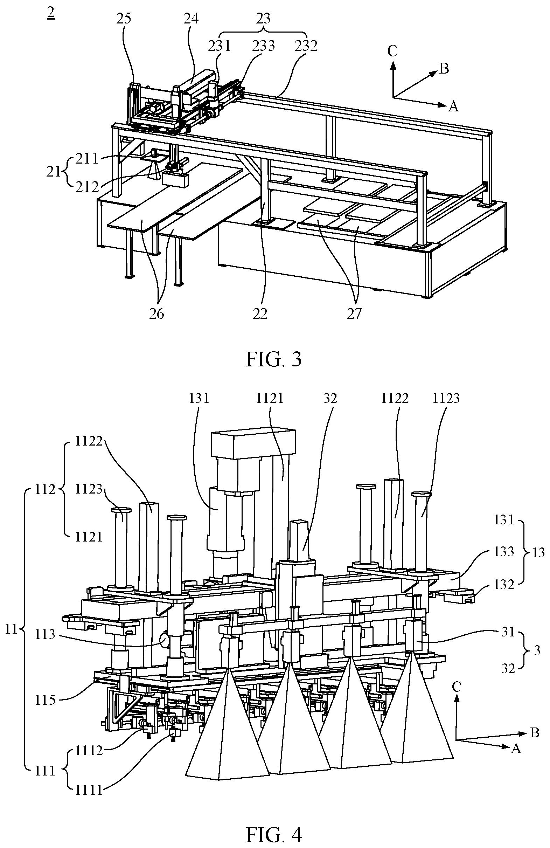

An embodiment of this disclosure provides a cell scanning and replacement system. Referring to FIG. 1, FIG. 2, and FIG. 3, FIG. 1 is a schematic structural diagram of a battery production line according to this disclosure, FIG. 2 is a schematic structural diagram of a testing device and an identification device in a cell scanning and replacement system according to this disclosure, and FIG. 3 is a schematic structural diagram of a replacement device in a cell scanning and replacement system according to this disclosure. The cell scanning and replacement system in the embodiment of this disclosure includes: a testing device 1, an identification device 3, and a replacement device 2. The testing device 1 includes a testing mechanism 11, and the testing mechanism 11 is configured to test a cell. The identification device 3 is connected to the testing device 1, and the identification device 3 is configured to acquire identification information of the cell, where the identification information is associated with a test result of the cell. The replacement device 2 is connected to the testing device 1, the replacement device 2 includes a replacement mechanism 21, where the replacement mechanism 21 is electrically connected to the identification device 3, and the replacement mechanism 21 is configured to replace a cell to be replaced based on the identification information.

In the embodiments of this disclosure, during the cell production process, a plurality of tests needs to be performed on the cells. The testing device 1 can be provided in the cell scanning and replacement system, and the testing device 1 includes a testing mechanism 11. Corresponding testing pieces can be provided in the testing mechanism 11 based on different testing needs. For example, the testing piece may be a measuring piece for conducting an OCV test on the cell; the testing piece may be a measuring piece for conducting an internal resistance test on the cell; or the testing piece may be a measuring piece for conducting a capacity test on the cell. The embodiments of this disclosure do not limit the measurement items of the testing mechanism 11.

In the embodiments of this disclosure, before testing a cell, it is necessary to identify which cell is to be tested, that is, each cell needs to be identified. The identification device 3 can be provided in the cell scanning and replacement system to identify each cell through the identification device 3. For example, the identification device 3 may be a device having an image recognition function, which can identify each cell by collecting an identification marker on the cell. The identification marker on the cell includes the identification information of the cell, and the identification information is used to uniquely identify a cell. The identification marker on the cell may be a QR code, a barcode, a digital code, or the like.

For example, after the testing of a cell is completed, the test result data of the cell can be bound with the identification information of the cell, that is, the test result data of the cell is stored in a storage location associated with the identification information of the cell, allowing acquisition of the test result data of the cell through the identification information. Additionally, data involved in the production process of the cell such as production data and process data can also be bound with the identification information of the cell.

In another example, as shown in FIG. 1, the identification device 3 can be connected to the testing device 1 through a transfer device 4, so that cells that have been identified can be transported to the testing device 1 via the transfer device 4. As shown in FIG. 2, the identification device 3 can also be integrated with the testing device 1, that is, the identification device 3 can be mounted on the testing device 1, allowing the cell to be identified first and then tested. The embodiments of this disclosure do not limit the arrangement position of the identification device 3.

In the embodiments of this disclosure, during the cell testing process, it is inevitable that some cells fail the test. The replacement device 2 can be provided in the cell scanning and replacement system, and the replacement device 2 can be connected to the testing device 1 through the transfer device 4, to transport cells that have completed the testing process to the replacement device 2 through the transfer device 4. The replacement mechanism 21 can be provided in the replacement device 2, to replace, through the replacement mechanism 21, the cells that need to be replaced on a module tray 5. During replacement, a defective cell can be removed from the module tray 5, and a spare cell can be placed in the corresponding position on the module tray 5.

For example, the replacement mechanism 21 can be electrically connected to the identification device 3, so that the replacement mechanism 21 can replace the cell to be replaced based on the identification information. For example, the replacement mechanism 21 and the identification device 3 can both be electrically connected to a controller to establish an electrical connection between the replacement mechanism 21 and the identification device 3. After the testing of the cell is completed, since the test result data of the cell has been bound with the identification information of the cell, a replace instruction carrying the identification information of the cell to be replaced can be delivered to the replacement mechanism 21. In response to the replace instruction, the replacement mechanism 21 can accurately and quickly determine the position of the cell to be replaced on the module tray 5, thereby accurately completing the replacement of the cell to be replaced.

The cell scanning and replacement system in the embodiments of this disclosure, with the testing device 1 including the testing mechanism 11, can test a cell through the testing mechanism 11, thereby improving the cell testing efficiency. Additionally, with the identification device 3 connected to the testing device 1, identification information of the cell can be acquired through the identification device 3, allowing the identification information of the cell to be bound with test result data of the cell, thereby establishing a relationship between the identification information and test result of the cell. Production data, process data, and the like of the cell can also be bound with the identification information of the cell, facilitating traceability of various data generated during the cell production process. Furthermore, the replacement device 2 connected to the testing device 1 is also provided, and the replacement mechanism 21 in the replacement device 2 is electrically connected to the identification device 3, allowing the replacement mechanism 21 to be controlled based on the identification information associated with the test result to quickly and accurately replace unqualified cells to be replaced, thereby improving the cell production efficiency.

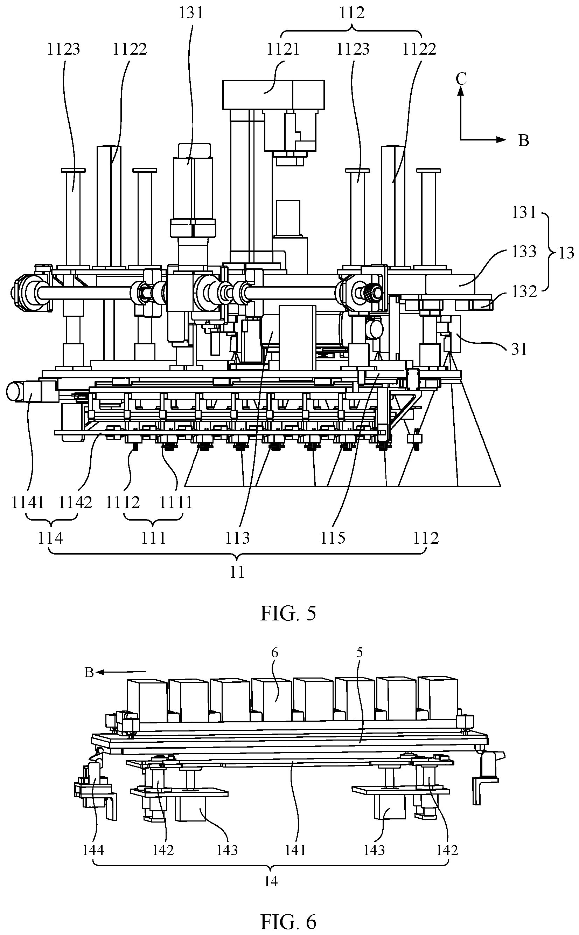

In some embodiments, referring to FIG. 4 and FIG. 5, FIG. 4 is a first schematic structural diagram of an identification device and a testing mechanism in a testing device according to this disclosure, and FIG. 5 is a second schematic structural diagram of an identification device and a testing mechanism in a testing device according to this disclosure. As shown in FIG. 2, FIG. 4, and FIG. 5, the testing device 1 in the embodiments of this disclosure further includes a testing bracket 12 and a testing longitudinal drive mechanism 13; where the testing longitudinal drive mechanism 13 is movably disposed on the testing bracket 12 along a first direction A, the testing mechanism 11 and the identification device 3 are both mounted on the testing longitudinal drive mechanism 13; and under the drive of the testing longitudinal drive mechanism 13, the testing mechanism 11 and the identification device 3 are both capable of moving along the first direction A.

In the embodiments of this disclosure, the testing bracket 12 can be provided in the testing device 1 to support and mount other components in the testing device 1 through the testing bracket 12. For example, the testing bracket 12 can be arranged as a frame-type structure.

In the embodiments of this disclosure, to enable the testing mechanism 11 to test cells over a relatively large range, the testing longitudinal drive mechanism 13 can be provided in the testing device 1. The testing longitudinal drive mechanism 13 can be mounted on the testing bracket 12, and both the testing mechanism 11 and the identification device 3 can be mounted on the testing longitudinal drive mechanism 13 to drive the movement of the testing mechanism 11 and the identification device 3 along the first direction A through the testing longitudinal drive mechanism 13. The first direction A may be a direction perpendicular to or approximately perpendicular to a direction in which the module tray 5 carrying the cells moves between the testing device 1 and the replacement device 2.

For example, as shown in FIG. 2, FIG. 4, and FIG. 5, the testing longitudinal drive mechanism 13 can be arranged as a structure including a first drive component 131, a first guide component 132, and a first bearing bracket 133. The first bearing bracket 133 is configured to mount and support the testing mechanism 11 and the identification device 3, and both the testing mechanism 11 and the identification device 3 can be mounted on the first bearing bracket 133. The first guide component 132 may include a slidingly connected guide rail and slider. The guide rail may be mounted on the testing bracket 12 along the first direction A, and the slider may be mounted on the first bearing bracket 133. In this way, the first bearing bracket 133 can move along the first direction A through the first guide component 132. The first drive component 131 may be a structure including a drive piece and a transmission component. The drive piece may be a motor such as a servo motor, and the drive piece is fixed to the first bearing bracket 133. The transmission component may include a meshed gear and rack. The rack may be mounted on the testing bracket 12, the rack also extends along the first direction A, and the gear is mounted on the output shaft of the servo motor. In this way, the first drive component 131 can drive the first bearing bracket 133 to move along the first direction A.

This embodiment uses the identification device 3 being mounted on the testing device 1 as an example to illustrate the cell scanning and replacement system provided in the embodiments of this disclosure, but it does not limit the identification device 3 to being mounted only on the testing device 1. The identification device 3 may also be mounted at positions such as a production station adjacent to the testing device 1.

In the above embodiment, since the testing bracket 12 is provided in the testing device 1, other components can be mounted on and supported by the testing bracket 12, and the testing device 1 can be installed at a testing station through the testing bracket 12. Additionally, the testing longitudinal drive mechanism 13 is movably disposed on the testing bracket 12, and the testing mechanism 11, the identification device 3, and the like can be mounted on the testing longitudinal drive mechanism 13, allowing the testing longitudinal drive mechanism 13 to drive the testing mechanism 11, the identification device 3, and the like to move along the first direction A, thereby testing the cells located at different positions.

In some embodiments, as shown in FIG. 4 and FIG. 5, the identification device 3 includes an identification component 31 and an identification vertical drive component 32, where the identification component 31 is mounted on the identification vertical drive component 32 and is configured to acquire the identification information; and the identification vertical drive component 32 is mounted on the testing longitudinal drive mechanism 13, and the identification vertical drive component 32 is configured to drive the identification component 31 to move along a third direction C toward or away from the cell, the third direction C forming an angle with the first direction A.

In the embodiments of this disclosure, the identification device 3 can be arranged as a structure including an identification component 31 and an identification vertical drive component 32 for driving the movement of the identification component 31.

For example, the identification component 31 can be arranged as a structure including a charge-coupled device (charge coupled device, CCD) camera. For example, at least two CCD cameras can be provided in the identification component 31 to capture an identification marker on a cell through the CCD cameras, thereby acquiring identification information of the cell based on the identification marker. The identification component 31 may alternatively be arranged as a structure including a scanning gun. The embodiments of this disclosure do not limit the specific structure of the identification component 31.

In another example, an identification vertical drive component 32 can be provided for the identification component 31, the identification vertical drive component 32 can be fixed to the first bearing bracket 133 in the testing longitudinal drive mechanism 13, and the identification component 31 can be fixed to a movable part of the identification vertical drive component 32. For example, the identification vertical drive component 32 may adopt a linear motor module to drive the movement of the identification component 31 along the third direction C through the linear motor module. The third direction C forms an angle with the first direction A, and the third direction C may be a vertical direction or a direction approximately vertical.

In the above embodiment, since the identification component 31 is provided in the identification device 3, the identification component 31 can identify an identification marker on the cell, thereby acquiring the identification information of the cell. Additionally, the identification vertical drive component 32 is also provided in the identification device 3 and the identification component 31 is mounted on the identification vertical drive component 32, allowing the identification vertical drive component 32 to drive the identification component 31 to move along the third direction C, thereby adjusting the distance between the identification component 31 and the cell. This enables the identification component 31 to quickly and accurately acquire identification markers on cells of various sizes, improving the applicability and identification efficiency of the identification device 3.

In some embodiments, as shown in FIG. 4, the testing mechanism 11 can be arranged as a structure including a testing component 111 and a testing vertical drive component 112, where the testing component 111 is mounted on the testing vertical drive component 112 and is configured to test a cell; and the testing vertical drive component 112 is mounted on the testing longitudinal drive mechanism 13, and the testing vertical drive component 112 is configured to drive the testing component 111 to move along the third direction C toward or away from the cell, bringing the testing component 111 into contact with or separation from the cell, the third direction C forming an angle with the first direction A.

In the embodiments of this disclosure, the testing component 111 can be provided in the testing mechanism 11, and the testing component 111 can be configured based on the test items performed on the cell. For example, the testing component 111 may be a measuring piece for conducting an OCV test on the cell. The embodiments of this disclosure do not limit the testing component 111.

In the embodiments of this disclosure, during the cell testing process, it is necessary to bring the testing component 111 into contact with the cell. Then, a testing vertical drive component 112 can be provided in the testing mechanism 11, and the testing component 111 can be mounted on the testing vertical drive component 112 to drive, through the testing vertical drive component 112, the testing component 111 to move toward the cell along the third direction C.

For example, the testing vertical drive component 112 may be a structural piece capable of producing linear motion, one end of the testing vertical drive component 112 is fixed to the first bearing bracket 133, and the testing component 111 is fixed to the output piece of the testing vertical drive component 112, thereby driving, through the output piece of the testing vertical drive component 112, the testing component 111 to move.

In the above embodiment, since the testing component 111 is provided in the testing mechanism 11, the testing component 111 can perform corresponding test items on the cell. Additionally, the testing vertical drive component 112 is provided in the testing mechanism 11 and the testing component 111 is mounted on the testing vertical drive component 112, so that the testing vertical drive component 112 can drive the testing component 111 to move along the third direction C, bringing the testing component 111 into contact with or separation from cells of different sizes and specifications, thereby improving the applicability of the testing mechanism 11.

In some embodiments, as shown in FIG. 4 and FIG. 5, the testing vertical drive component 112 can be arranged as a structure including a vertical power component 1121, a vertical assistance component 1122, and a vertical guide component 1123, where the vertical guide component 1123 has one end mounted on the testing longitudinal drive mechanism 13 and another end connected to the testing component 111, and is configured to guide the testing component 111 to move along the third direction C; the vertical power component 1121 has one end connected to the testing longitudinal drive mechanism 13 and another end connected to the testing component 111, and is configured to drive the testing component 111 to move along the third direction C; and the vertical assistance component 1122 has one end connected to the testing longitudinal drive mechanism 13 and another end connected to the testing component 111, and under the action of the vertical assistance component 1122, the testing component 111 has a tendency to move along the third direction C toward the testing longitudinal drive mechanism 13.

In the embodiments of this disclosure, the vertical guide component 1123 can be provided in the testing vertical drive component 112 to restrict the movement path of the testing component 111 through the vertical guide component 1123, thereby limiting the movement path of the testing component 111 with respect to the testing longitudinal drive mechanism 13 to be the third direction C.

For example, to facilitate the installation of the testing component 111, a first connecting piece 115 can be provided, and the testing component 111 can be mounted on the first connecting piece 115. The vertical guide component 1123 can be arranged as a structure including a structure with a slidingly nested guide sleeve and guide post, the guide sleeve is fixed to the first bearing bracket 133, and one end of the guide post is fixedly connected to the first connecting piece 115. In this way, the guide post can slide along the third direction C through the guide sleeve to restrict the movement of the testing component 111 along the third direction C.

In another example, the vertical power component 1121 can be arranged as a structure including a servo motor and a ball screw, with the output shaft of the servo motor drivingly connected to the nut of the ball screw, and the screw of the ball screw connected to the first connecting piece 115. In this way, the servo motor can drive the nut to rotate, causing the screw to move along the third direction C, thereby providing power to the testing component 111 through the screw to drive the testing component 111 to move along the third direction C.

In still another example, the vertical assistance component 1122 can be arranged as a structure including a cylinder, the cylinder barrel is fixed to the first bearing bracket 133, the piston rod of the cylinder is fixed to the first connecting piece 115, and the cylinder is configured such that the piston rod of the cylinder has a tendency to retract. In this way, the cylinder can provide a pulling force for driving the testing component 111 toward the first bearing bracket 133, but this pulling force cannot directly drive the testing component 111 to move in a direction toward the first bearing bracket 133. That is, the vertical assistance component 1122 can reduce the magnitude of the driving force that the vertical power component 1121 needs to provide to the testing component 111.

In the above embodiment, since the vertical guide component 1123 is provided in the testing vertical drive component 112, the vertical guide component 1123 can restrict the movement direction of the testing component 111 with respect to the testing longitudinal drive mechanism 13 to the third direction C. Additionally, the vertical power component 1121 is provided between the testing component 111 and the testing longitudinal drive mechanism 13, and the vertical power component 1121 can provide driving force for the testing component 111, driving the testing component 111 to move along the third direction C. Furthermore, the vertical assistance component 1122 is provided between the testing component 111 and the testing longitudinal drive mechanism 13, and the vertical assistance component 1122 can reduce the magnitude of the driving force required to be provided by the vertical power component 1121 to the testing component 111, thereby reducing the load on the vertical power component 1121 and extending the service life of the vertical power component 1121.

In some embodiments, as shown in FIG. 4 and FIG. 5, the testing mechanism 11 further includes a testing transverse drive component 113, where one end of the testing transverse drive component 113 is mounted on the testing vertical drive component 112, the testing component 111 is connected to the testing transverse drive component 113, and the testing transverse drive component 113 is configured to drive the testing component 111 to move along a second direction B, the second direction B forming an angle with each of the first direction A and the third direction C.

In the embodiments of this disclosure, a testing transverse drive component 113 can also be provided in the testing mechanism 11, the testing transverse drive component 113 can be mounted on the first connecting piece 115, and the testing component 111 can be mounted on the testing transverse drive component 113 to drive the movement of the testing component 111 along the second direction B through the testing transverse drive component 113. The second direction B may be a direction consistent with a direction in which the module tray 5 carrying the cells moves between the testing device 1 and the replacement device 2.

For example, the testing transverse drive component 113 can be arranged as a structure including a linear motor module and a guide component. The guide component may include a slidingly connected guide rail and slider, with the guide rail connected to the testing component 111 and the slider mounted on the first connecting piece 115, where the guide rail extends along the second direction B. The linear motor module is fixed to the first connecting piece 115, and the output piece of the linear motor module is connected to the testing component 111. In this way, the linear motor module can drive the movement of the testing component 111 along the second direction B through the guide component.

In the above embodiment, since the testing transverse drive component 113 is provided in the testing mechanism 11 and the testing component 111 is mounted on the testing transverse drive component 113, the testing transverse drive component 113 can drive the testing component 111 to move along the second direction B. This allows for adjustment of the position of the testing component 111 with respect to the cell in the second direction B, leaving the testing component 111 at a position opposite the cell in the second direction B.

In some embodiments, as shown in FIG. 4 and FIG. 5, the testing mechanism 11 further includes a testing longitudinal drive component 114, and the testing component 111 includes a first testing piece 1111 and a second testing piece 1112, where the first testing piece 1111 is fixedly disposed on the testing transverse drive component 113; the second testing piece 1112 is slidably disposed on the testing transverse drive component 113; and the testing longitudinal drive component 114 has one end connected to the testing transverse drive component 113 and another end connected to the second testing piece 1112, and the testing longitudinal drive component 114 is configured to drive the second testing piece 1112 to move along the first direction A toward or away from the first testing piece 1111.

In the embodiments of this disclosure, a cell typically has two poles, and during some test items on the cell, it is necessary to make the testing component 111 come into contact with both the two poles. Then, the testing component 111 can be arranged as a structure including a first testing piece 1111 and a second testing piece 1112. During cell testing, corresponding test devices can be mounted on the first testing piece 1111 and/or the second testing piece 1112 based on different testing needs.

For example, the first testing piece 1111 can be fixed to the testing transverse drive component 113, and the second testing piece 1112 can be slidably mounted on the testing transverse drive component 113 along the first direction A through a suitable guide rail and slider.

In another example, a testing longitudinal drive component 114 can be provided between the first connecting piece 115 and the second testing piece 1112. The testing longitudinal drive component 114 can be arranged as a structure including an adjustment drive piece 1141 and a pushing piece 1142. The adjustment drive piece 1141 is fixed to the first connecting piece 115, the pushing piece 1142 is connected to the second testing piece 1112, and the pushing piece 1142 is connected to the output piece of the adjustment drive piece 1141. The adjustment drive piece 1141 can drive the pushing piece 1142 to move along the first direction A to drive the second testing piece 1112 to move along the first direction A. For example, the adjustment drive piece 1141 may be a linear motor module.

In the above embodiment, since the testing component 111 is arranged as a structure including a first testing piece 1111 and a second testing piece 1112, and the second testing piece 1112 is slidably disposed on the testing transverse drive component 113 along the first direction A, the second testing piece 1112 can move along the first direction A. Additionally, the testing longitudinal drive component 114 is provided between the testing transverse drive component 113 and the second testing piece 1112, and the testing longitudinal drive component 114 can drive the second testing piece 1112 to move along a direction toward or away from the first testing piece 1111, thereby adjusting the spacing between the second testing piece 1112 and the first testing piece 1111. This allows the spacing between the second testing piece 1112 and the first testing piece 1111 to match the spacing between the poles on cells of different sizes and specifications, thereby improving the applicability of the testing mechanism 11.

In some embodiments, referring to FIG. 6, FIG. 6 is a schematic structural diagram of a testing lifting mechanism in a testing device according to this disclosure. As shown in FIG. 2 and FIG. 6, the testing device 1 further includes a testing lifting mechanism 14, and the testing lifting mechanism 14 includes a testing lifting bracket 141, a testing lifting guide component 142, a testing lifting drive component 143, and a testing lifting limit component 144, where the testing lifting guide component 142 has one end connected to the testing bracket 12 and another end connected to the testing lifting bracket 141, the testing lifting guide component 142 is configured to guide the testing lifting bracket 141 to move along the third direction C, and the testing lifting bracket 141 is configured to support a module tray 5; the testing lifting drive component 143 has one end connected to the testing lifting guide component 142 and another end connected to the testing lifting bracket 141, and the testing lifting drive component 143 is configured to drive the testing lifting bracket 141 to move along the third direction C; and the testing lifting limit component 144 is mounted on the testing bracket 12 and is configured to restrict a position of the module tray 5 with respect to the testing bracket 12.

In the embodiments of this disclosure, after the module tray 5 carrying cells is transported to the testing device 1 through the transfer device 4, it is necessary to position the module tray 5. In this case, a testing lifting mechanism 14 can be provided in the testing device 1 to position the module tray 5 through the testing lifting mechanism 14. For example, as shown in FIG. 2, two testing lifting mechanisms 14 can be provided in the testing device 1, with the two testing lifting mechanisms 14 arranged side by side along the first direction A.

For example, a lifting bracket can be provided in the testing lifting mechanism 14 to lift and support the module tray 5 along the third direction C through the lifting bracket. A testing lifting guide component 142 can be provided in the testing lifting mechanism 14, and the testing lifting guide component 142 can be arranged as a structure including a slidingly nested guide sleeve and guide post. The guide sleeve is fixed to the testing bracket 12, and one end of the guide post is connected to the lifting bracket. In this way, the lifting guide component can restrict the movement direction of the lifting bracket to the third direction C.

In another example, a testing lifting drive component 143 can be provided between the testing bracket 12 and the lifting bracket, for example, the testing lifting drive component 143 may be a drive piece such as a cylinder, a hydraulic cylinder, or an electric cylinder. The testing lifting drive component 143 is fixed to the testing bracket 12, and the output shaft of the testing lifting drive component 143 is connected to the testing lifting bracket 141. The testing lifting drive component 143 can drive the testing lifting bracket 141 to move along the third direction C.

In still another example, along the movement path of the module tray 5 (the second direction B in the figure), a testing lifting limit component 144 can be provided in the testing lifting mechanism 14. For example, the testing lifting limit component 144 can be disposed at the exit of the module tray 5 on the testing bracket 12. The testing lifting limit component 144 may a structure including a limit cylinder and a limit piece, with the limit piece mounted at the end of the piston rod of the limit cylinder, and the limit cylinder fixed to the testing bracket 12. The limit cylinder can drive the limit piece to move along the third direction C, causing the limit piece to block the movement path of the module tray 5 to restrict the position of the module tray 5 with respect to the testing bracket 12.

In the above embodiment, since the testing lifting mechanism 14 is provided in the testing device 1, the testing lifting mechanism 14 can lift the module tray 5 along the third direction C to restrict the position of the module tray 5 in the third direction C. Additionally, the testing lifting limit component 144 is provided in the testing lifting mechanism 14, and the testing lifting limit component 144 can restrict the position of the module tray 5 with respect to the testing bracket 12 along the second direction B.

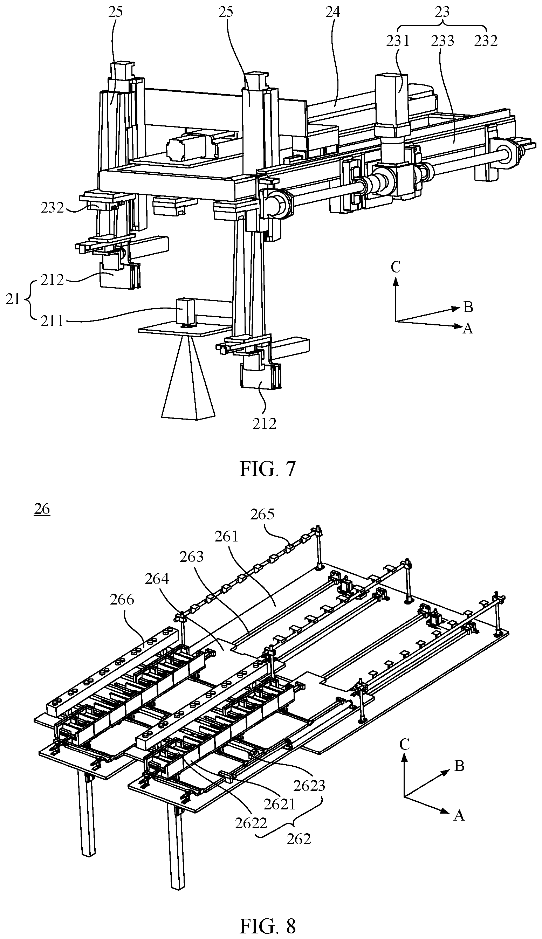

In some embodiments, referring to FIG. 7, FIG. 7 is a schematic structural diagram of a replacement mechanism in a replacement device according to this disclosure. As shown in FIG. 3 and FIG. 7, the replacement device 2 further includes a replacement bracket 22 and a replacement longitudinal drive mechanism 23, where the replacement longitudinal drive mechanism 23 is movably disposed on the replacement bracket 22 along the first direction A, the replacement mechanism 21 is connected to the replacement longitudinal drive mechanism 23, and the replacement longitudinal drive mechanism 23 is configured to drive the replacement mechanism 21 to move along the first direction A with respect to the replacement bracket.

In the embodiments of this disclosure, a replacement bracket 22 can be provided in the replacement device 2 to support and mount other components in the replacement device 2 through the replacement bracket 22. For example, the replacement bracket 22 can be arranged as a frame-type structure.

In the embodiments of this disclosure, to enable the replacement mechanism 21 to move between the storage position of spare cells and the position of the cell to be replaced, a replacement longitudinal drive mechanism 23 can be provided in the replacement device 2. The replacement longitudinal drive mechanism 23 can be mounted on the replacement bracket 22, and the replacement mechanism 21 can be mounted on the replacement longitudinal drive mechanism 23 to drive the movement of the replacement mechanism 21 along the first direction A through the replacement longitudinal drive mechanism 23. The first direction A may be a direction perpendicular to or approximately perpendicular to a direction in which the module tray 5 carrying cells moves from the testing device 1 to the replacement device 2.

For example, as shown in FIG. 3 and FIG. 7, the replacement longitudinal drive mechanism 23 can be arranged as a structure including a second drive component 231, a second guide component 232, and a second bearing bracket 233. The second bearing bracket 233 can be arranged as a frame-type structure, and the replacement mechanism 21 can be mounted on the second bearing bracket 233. The second guide component 232 may include a slidingly connected guide rail and slider, with the guide rail mounted on the replacement bracket 22 along the first direction A and the slider mounted on the second bearing bracket 233. In this way, the second bearing bracket 233 can move along the first direction A through the second guide component 232. The second drive component 231 may be a structure including a drive piece and a transmission component. The drive piece may be a motor such as a servo motor, and the drive piece is fixed to the second bearing bracket 233. The transmission component may include a meshed gear and rack. The rack may be mounted on the replacement bracket 22, the rack also extends along the first direction A, and the gear is mounted on the output shaft of the servo motor. In this way, the second drive component 231 can drive the second bearing bracket 233 to move along the first direction A.

In the above embodiment, since the replacement bracket 22 is provided in the replacement device 2, other components can be mounted on and supported by the replacement bracket 22, and the replacement device 2 can be installed through the replacement bracket 22 at a replacement station for replacing cells to be replaced. Additionally, the replacement longitudinal drive mechanism 23 is movably disposed on the replacement bracket 22, and the replacement mechanism 21 can be mounted on the replacement longitudinal drive mechanism 23, allowing the replacement longitudinal drive mechanism 23 to drive the replacement mechanism 21 to move along the first direction A, thereby replacing cells to be replaced at different positions.

In some embodiments, as shown in FIG. 3 and FIG. 7, the replacement device 2 further includes a replacement transverse drive component 24, where the replacement transverse drive component 24 is mounted on the replacement longitudinal drive mechanism 23, the replacement mechanism 21 is connected to the replacement transverse drive component 24, and the replacement transverse drive component 24 is configured to drive the replacement mechanism 21 to move along the second direction B.

In the embodiments of this disclosure, a replacement transverse drive component 24 can also be provided in the replacement device 2, the replacement transverse drive component 24 can be mounted on the second bearing bracket 233, and the replacement mechanism 21 can be mounted on the replacement transverse drive component 24 to drive the movement of the replacement mechanism 21 along the second direction B through the replacement transverse drive component 24. The second direction B may be a direction consistent with a direction in which the module tray 5 moves between the testing device 1 and the replacement device 2.

For example, the replacement transverse drive component 24 can be arranged as a structure including a linear motor module. The linear motor module is fixed to the second bearing bracket 233, the linear motor module extends along the second direction B, and the output piece of the linear motor module is connected to the replacement mechanism 21. In this way, the linear motor module can drive the replacement mechanism 21 to move along the second direction B.

In the above embodiment, since the replacement transverse drive component 24 is provided in the replacement device 2 and the replacement mechanism 21 is connected to the replacement transverse drive component 24, the replacement transverse drive component 24 can drive the replacement mechanism 21 to move along the second direction B, thereby adjusting the position of the replacement mechanism 21 with respect to the spare cell and the cell to be replaced in the second direction B. This allows the replacement mechanism 21 at a position opposite the spare cell and the cell to be replaced in the second direction B.

In some embodiments, as shown in FIG. 3 and FIG. 7, the replacement device 2 further includes a replacement vertical drive component 25, where the replacement vertical drive component 25 is mounted on the replacement transverse drive component 24, the replacement mechanism 21 is mounted on the replacement vertical drive component 25, and the replacement vertical drive component 25 is configured to drive the replacement mechanism 21 to move along the third direction C.

In the embodiments of this disclosure, the replacement vertical drive component 25 can also be provided in the replacement device 2, the replacement vertical drive component 25 can be mounted on the output piece of the replacement transverse drive component 24, and the replacement mechanism 21 can be mounted on the replacement vertical drive component 25 to drive the movement of the replacement mechanism 21 along the third direction C through the replacement vertical drive component 25.

For example, the replacement vertical drive component 25 can be arranged as a structure including a linear motor module. The linear motor module is fixed to the output piece of the transverse drive component, the linear motor module extends along the third direction C, and the replacement mechanism 21 is fixed to the output piece of the linear motor module. In this way, the linear motor module can drive the replacement mechanism 21 to move along the third direction C.

In another example, two replacement vertical drive components 25 can be provided in the replacement device 2, and one replacement mechanism 21 can be mounted on each replacement vertical drive component 25. In this way, one replacement mechanism 21 can grasp the cell to be replaced, and the other replacement mechanism 21 can grasp the spare cell.

In the above embodiment, since the replacement vertical drive component 25 is provided in the replacement device 2 and the replacement mechanism 21 is mounted on the replacement vertical drive component 25, the replacement vertical drive component 25 can drive the replacement mechanism 21 to move along the third direction C, enabling the replacement mechanism 21 to move toward or away from the cell to be replaced or the spare cell along the third direction C.

In some embodiments, as shown in FIG. 3 and FIG. 7, the replacement mechanism 21 includes a collection component 211 and a gripper component 212, where the collection component 211 is configured to acquire identification information of the spare cell; and the gripper component 212 is configured to grasp or release a cell.

In the embodiments of this disclosure, the replacement mechanism 21 can be arranged as a structure including a collection component 211 and a gripper component 212. For example, one set of gripper components 212 can be mounted on each of the two replacement vertical drive components 25, and one collection component 211 can be mounted on one of the two replacement vertical drive components 25.

For example, the collection component 211 can be arranged as a structure including a CCD camera, or the collection component 211 can be arranged as a structure including a scanning gun. The embodiments of this disclosure do not limit the specific structure of the collection component 211.

In another example, the gripper component 212 can be arranged as a structure including a fixed piece, a gripper piece, and a drive piece. The fixed piece is fixedly mounted on the replacement vertical drive component 25, the gripper piece is slidably mounted on the replacement vertical drive component 25, the drive piece is mounted on the replacement vertical drive component 25, and the output piece of the drive piece is connected to the gripper piece. The drive piece can drive the gripper piece to move in a direction toward or away from the fixed piece, thereby completing the grasping or releasing of the cell.

In the above embodiment, since the collection component 211 is provided in the replacement mechanism 21, the collection component 211 can collect the identification marker on the spare cell, to obtain the identification information of the spare cell, thereby acquiring the test data and production data of the spare cell. Additionally, the gripper component 212 is provided in the replacement mechanism 21, and the gripper component 212 can grasp or release the cell to be replaced and the spare cell, thereby removing the cell to be replaced from the module tray 5 and placing the spare cell into the module tray 5.

In some embodiments, referring to FIG. 8, FIG. 8 is a schematic structural diagram of a storage mechanism in a replacement device according to this disclosure. As shown in FIG. 3 and FIG. 8, the replacement device 2 further includes a storage mechanism 26, the storage mechanism 26 including a storage bracket 261, a storage tray 262, and a storage guide component 263, where the storage bracket 261 is mounted on the replacement bracket 22; the storage guide component 263 is mounted on the storage bracket 261 and extends along the second direction B; and the storage tray 262 is mounted on the storage guide component 263, and the storage tray 262 is capable of moving along the second direction B through the storage guide component 263.

In the embodiments of this disclosure, the storage mechanism 26 can be provided in the replacement device 2 to store spare cells through the storage mechanism 26. The storage mechanism 26 can also store cells to be replaced that are removed from the module tray 5.

For example, the storage bracket 261 can be provided in the storage mechanism 26, and the storage bracket 261 can be fixed to the replacement bracket 22 to mount and support other components in the storage mechanism 26 through the storage bracket 261.

In another example, the storage guide component 263 can be provided on the storage bracket 261, and the storage guide component 263 may include a slidingly connected slider and guide rail. The guide rail can extend along the second direction B and can be fixed to the storage bracket 261, and the slider can be fixed to the storage tray 262, enabling the storage tray 262 to move with respect to the replacement bracket 22 along the second direction B.

In still another example, the storage tray 262 can be arranged as a structure having a plurality of storage positions to place cells to be replaced and spare cells on the storage tray 262.

In the above embodiment, since the storage bracket 261 is provided in the storage mechanism 26, the storage tray 262 can be disposed on the storage bracket 261. Additionally, the storage guide component 263 is provided between the storage tray 262 and the storage bracket 261, the storage tray 262 can move along the second direction B with respect to the replacement bracket 22, allowing the storage tray 262 to move to a position far from the replacement mechanism 21 for placing the spare cell on the storage tray 262, as well as allowing the storage tray 262 to move to a position close to the replacement mechanism 21.

In some embodiments, as shown in FIG. 8, the storage tray 262 includes a positioning piece 2621, a clamping piece 2622, and a clamping drive component 2623, where the positioning piece 2621 is mounted on the storage guide component 263; the clamping drive component 2623 has one end connected to the storage guide component 263 and another end connected to the clamping piece 2622, and the clamping drive component 2623 is configured to drive the clamping piece 262 2 to move along a direction toward or away from the positioning piece 2621 to clamp or release a cell.

In the embodiments of this disclosure, the tray bracket 264 can be provided in the storage mechanism 26, and the tray bracket 264 is fixedly connected to the slider in the storage guide component 263. The storage tray 262 can be arranged as a structure including a positioning piece 2621, a clamping piece 2622, and a clamping drive component 2623. The positioning piece 2621 is fixed to the tray bracket 264, the clamping drive component 2623 is fixed to the tray bracket 264, and the clamping piece 2622 is connected to the output piece of the clamping drive component 2623, allowing the clamping drive component 2623 to drive the clamping piece 2622 to move in a direction toward or away from the positioning piece 2621. In this way, the spare cell can be clamped and fixed in a storage space enclosed by the positioning piece 2621 and the clamping piece 2622, meaning that one storage position is formed by one positioning piece 2621 and one clamping piece 2622.

For example, a detection grating 265 can also be provided in the storage mechanism 26 to detect the position of the spare cell placed on the storage tray 262 through the detection grating 265, ensuring that the spare cell is placed in the correct storage position.

In another example, an indication component 266 can also be provided in the storage mechanism 26. For example, one set of indicator lights can be provided for all storage positions on the storage tray 262, with each indicator light indicating whether a spare cell or a cell to be replaced removed from the module tray 5 is stored at a corresponding storage position. For example, the indication component 266 can be arranged as a structure including red and green indicators.

In the above embodiment, since the positioning piece 2621 and the clamping piece 2622 are provided in the storage tray 262, a storage space can be formed by the positioning piece 2621 and the clamping piece 2622 to place the cell to be placed at a determined position. Additionally, the clamping piece 2622 is mounted on the clamping drive component 2623, the clamping drive component 2623 can drive the clamping piece 2622 to move, thereby implementing clamping and fixation of cells of different sizes and specifications.

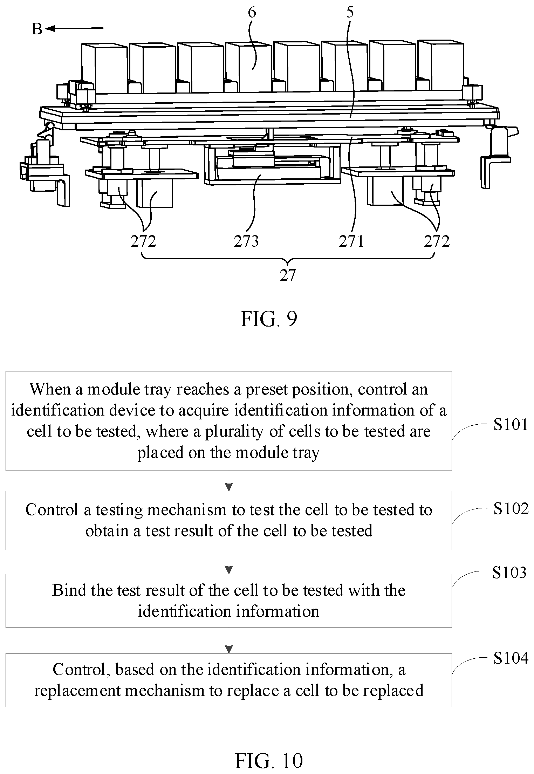

In some embodiments, referring to FIG. 9, FIG. 9 is a schematic structural diagram of a replacement lifting mechanism in a replacement device according to this disclosure. As shown in FIG. 3 and FIG. 9, the replacement device 2 further includes a replacement lifting mechanism 27, the replacement lifting mechanism 27 including a replacement lifting bracket 271, a replacement lifting component 272, and a release component 273, where the replacement lifting component 272 has one end connected to the replacement bracket 22 and another end connected to the replacement lifting bracket 271, the replacement lifting component 272 is configured to drive the replacement lifting bracket 271 to move along the third direction C, and the replacement lifting bracket 271 is configured to support the module tray 5; and the release component 273 is mounted on the replacement lifting bracket 271 and is configured to drive a tray clamping piece 2622 on the module tray 5 to move, causing the module tray 5 to release the clamping of a cell 6.

In the embodiments of this disclosure, to position the module tray 5 transported to the replacement device 2, the replacement lifting mechanism 27 can be provided in the replacement device 2 to position the module tray 5 through the replacement lifting mechanism 27. Additionally, an operation can be performed on the module tray 5, causing the clamping piece 2622 on the module tray 5 to release the clamping of the cell 6.

For example, as shown in FIG. 3, two replacement lifting mechanisms 27 can be provided in the replacement device 2, allowing two module trays 5 to be stationed in the replacement device 2 at the same time, thereby improving the efficiency of replacing cells to be replaced.

In another example, as shown in FIG. 9, the replacement lifting bracket 271 can be provided in the replacement lifting mechanism 27 to support the module tray 5 through the replacement lifting bracket 271. The replacement lifting component 272 can be provided between the replacement bracket 22 and the replacement lifting bracket 271. The replacement lifting component 272 may be a structure including a replacement lifting drive piece and a replacement lifting guide component, and the replacement lifting guide component has one end connected to the replacement lifting bracket 271 and another end connected to the replacement bracket 22, to restrict the movement of the replacement lifting bracket 271 to only along the third direction C. The replacement lifting drive piece may be a drive piece such as a cylinder to drive the replacement lifting bracket 271 to move along the third direction C through the replacement lifting drive piece.

In still another example, the release component 273 can be provided in the replacement lifting mechanism 27, and the release component 273 can be fixed to the replacement lifting bracket 271. The release component 273 may be a structure including a linear motor module, with the output piece of the linear motor module extending to a side of the replacement lifting bracket 271 facing the module tray 5, allowing the output piece of the linear motor module to drive the tray clamping piece 2622 on the module tray 5 to move.

In the above embodiment, since the replacement lifting mechanism 27 is provided in the replacement device 2, the replacement lifting mechanism 27 can restrict the position of the module tray 5, so that the module tray 5 stops at a determined position with respect to the replacement mechanism 21. Additionally, the release component 273 is provided in the replacement lifting mechanism 27, and the release component 273 can drive the tray clamping piece 2622 on the module tray 5 to move, thereby allowing the module tray 5 to release the clamping of the cell 6, facilitating the grasping of the cell to be replaced by the gripper component 212 in the replacement mechanism 21.

An embodiment of this disclosure further provides a battery production line. As shown in FIG. 1, the battery production line includes: a cell assembly system, the cell scanning and replacement system according to any one of the above embodiments, and a storage system; where the cell assembly system is configured to assemble a cell to obtain the cell to be tested; the cell scanning and replacement system is configured to test the cell to be tested and replace a cell to be replaced; and the storage system is configured to store a cell that has completed test items.

In the embodiments of this disclosure, a cell assembly system can be provided in the battery production line to assemble the components constituting a cell through the cell assembly system, thereby obtaining a cell to be tested.

In the embodiments of this disclosure, the storage system can be provided in the battery production line. The storage system includes a plurality of storage positions. Individual cells or assembled cell modules can be stored at the storage positions.

The battery production line of the embodiments of this disclosure includes the cell scanning and replacement system according to any one of the above implementations, and therefore has the same technical effects, that is, facilitating traceability of various data generated during the cell production process and improving the production efficiency of cells, thereby improving the production efficiency of batteries.

An embodiment of this disclosure further provides a control method of a cell scanning and replacement system, where the cell scanning and replacement system includes a host computer, a controller, an identification device, a testing device, and a replacement device, the testing device including a testing mechanism, and the replacement device including a replacement mechanism. Referring to FIG. 10, FIG. 10 is a first schematic flowchart of a control method of a cell scanning and replacement system according to this disclosure. The method includes the following steps S101 to S104.

S101. When a module tray reaches a preset position, control the identification device to acquire identification information of a cell to be tested, where a plurality of cells to be tested are placed on the module tray.

In some embodiments, the host computer may refer to any computer system used for monitoring, tracking, and controlling the production process, and the host computer can perform integrated management for the production process, resources, data, and the like on the production line. For example, the host computer may be a manufacturing execution system (Manufacturing Execution System, MES).

In some embodiments, the controller may refer to any control device, and further, may be a control device in industrial production. For example, the controller may be a programmable logic controller (Programmable Logic Controller, PLC). At least one controller can be provided for each device in the cell scanning and replacement system, and the controller can be configured as capable of exchanging information with the identification device, the testing device, and the replacement device to control the identification device, the testing device, and the replacement device to perform their respective actions, thereby implementing their respective functions. The controller is electrically connected to the host computer to implement data and information exchange between the controller and the host computer.

In some embodiments, the module tray is configured to carry a cell to be tested. One module tray may carry all cells to be tested in one cell module, or may carry other quantities of cells to be tested.

In the embodiments of this disclosure, a position sensor on the testing lifting mechanism of the testing device can detect whether the module tray has moved to the preset position. When it is detected that the module tray has been transported to the preset position via the transfer device, the identification device provided on the testing device can be controlled to acquire the identification marker on the cell to be tested. For example, the identification marker may be a QR code, a barcode, a digital code, or the like. After the identification device acquires the identification marker, the identification marker can be identified to obtain the identification information of each cell to be tested, and the identification information can be uploaded to the controller, where the identification information is used to uniquely identify a cell to be tested.

S102. Control the testing mechanism to test the cell to be tested to obtain a test result of the cell to be tested.

In some embodiments, after the identification information of the cell to be tested is acquired, a test instruction can be delivered to the testing mechanism, and the testing mechanism performs, in response to the test instruction, corresponding test items on the cell to be tested through the testing device on the testing mechanism. After the testing of the cell to be tested is completed, the test result of the cell to be tested can be obtained. The test data including the test result can be uploaded to the controller.

S103. Bind the test result of the cell to be tested with the identification information.

In some embodiments, the test data of the test result of the cell to be tested can be bound with the identification information of the cell, that is, an association is established between the test data of the testing mechanism and the identification information of each cell to be tested, so that the test result of the cell to be tested can be found based on the identification information of the cell to be tested.

S104. Control, based on the identification information, the replacement mechanism to replace a cell to be replaced.

In some embodiments, during the testing process of the cells to be tested, if the test results of some cells to be tested indicate that such cells are unqualified, these unqualified cells are marked as cells to be replaced. At this time, the positions of the cells to be replaced on the module tray can be determined by retrieving the identification information of the cell to be replaced. The identification information of the cell to be replaced is associated with the test result of the cell to be replaced, where the test result of the cell to be replaced indicates that the cell to be replaced is unqualified. Thus, the test result data of the cell to be replaced can be obtained based on the identification information, and the test result data is verified, thereby determining that the cell to be replaced is an unqualified cell. The controller can deliver a replace instruction carrying the identification information of the cell to be replaced to the replacement mechanism. In response to the replace instruction, the replacement mechanism uses a spare cell to replace the cell to be replaced, thereby ensuring that all cells on the module tray are cells with qualified test results.

In the above embodiment, the identification device is controlled to acquire the identification information of the cell to be tested, so that the identification information of each cell to be tested on the module tray can be determined, thereby uniquely identifying each cell to be tested through the identification information. Additionally, the testing mechanism is controlled to perform test items on the cell to be tested, so that the test result of the cell to be tested can be obtained. Moreover, the test result of the cell to be tested is bound with the identification information, so that the test data including the test result of each cell can be retrieved through the identification information, facilitating traceability of the cell testing process. Furthermore, based on the identification information of the cell to be tested, the replacement mechanism is controlled to replace the cell to be replaced, improving the accuracy and efficiency of replacing the cell to be replaced, thereby improving the cell production efficiency.

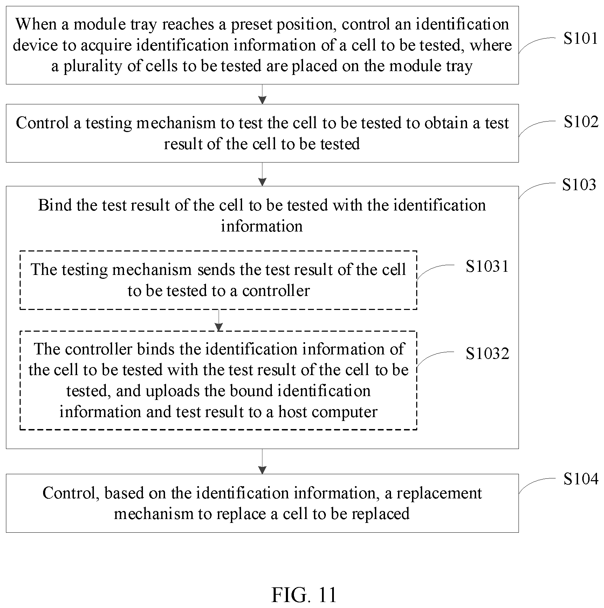

Referring to FIG. 11, FIG. 11 is a second schematic flowchart of a control method of a cell scanning and replacement system according to this disclosure. The replacement mechanism includes a collection component and a gripper component. Based on FIG. 10, step S103 in FIG. 10 can be implemented through the following steps S1031 and S1032.

S1031. The testing mechanism sends the test result of the cell to be tested to the controller.

In some embodiments, after the testing mechanism completes the testing of the cell to be tested, the test data including the test result of the cell to be tested can be sent to the controller, allowing the controller to bind the test result of each cell to be tested with the identification information of the cell to be tested.

S1032. The controller binds the identification information of the cell to be tested with the test result of the cell to be tested, and uploads the bound identification information and test result to the host computer.

In some embodiments, after the controller receives the test result of the cell to be tested from the testing mechanism, the controller can bind the identification information of the cell to be tested, previously received from the identification device, with the test result of the cell to be tested, thereby establishing an association between the test result and identification information of each cell to be tested.

In the above embodiment, since the controller is electrically connected to the identification device and the testing device, the identification information and the test result of the cell to be tested are bound through the controller, reducing the data transmission paths and the number of transmissions, thereby improving the efficiency of binding the identification information and the test result.

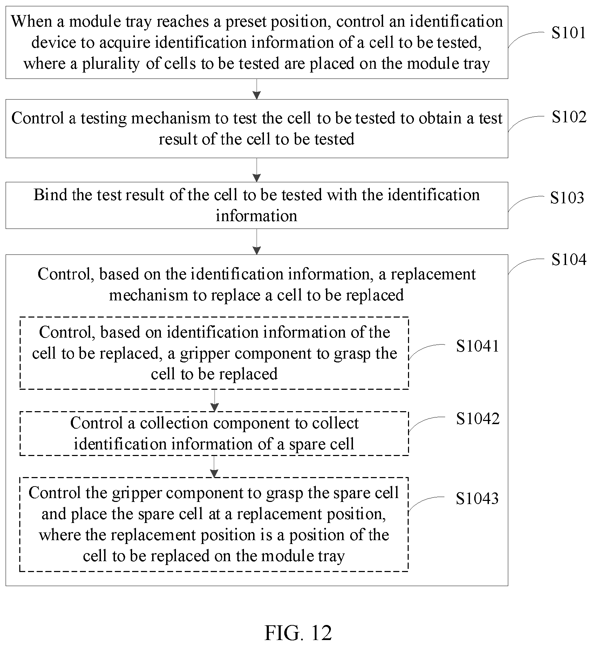

Referring to FIG. 12, FIG. 12 is a third schematic flowchart of a control method of a cell scanning and replacement system according to this disclosure. The replacement mechanism includes a collection component and a gripper component. Based on FIG. 10, step S104 in FIG. 10 can be implemented through the following steps S1041 to S1043.

S1041. Control, based on the identification information of the cell to be replaced, the gripper component to grasp the cell to be replaced.

In some embodiments, after the controller delivers a replace instruction carrying the identification information of the cell to be replaced to the replacement mechanism, the gripper component in the replacement mechanism can be controlled based on the identification information to grasp the cell to be replaced on the module tray and place the cell to be replaced in the storage mechanism of the replacement device.

For example, step S1041 can be implemented through the following steps S10411 to S10413.

S10411. The testing mechanism sends the test result of the cell to be tested to the controller.

In some embodiments, after the testing mechanism completes the testing of the cell to be tested, the testing mechanism can send the test result of each cell to be tested to the controller, and the controller can complete the binding of the identification information and test result of the cell to be tested.

S10412. In a case that the controller determines that the test result is unqualified, the controller delivers a grasp instruction to the gripper component, where the grasp instruction carries identification information of the cell to be replaced that matches the unqualified test result.

In some embodiments, during the process of the controller completing the binding of the test result and identification information of the cell to be tested, the controller can judge the received test result based on a preset test result judgment condition, so as to determine whether the test result of the cell to be tested is qualified.

For example, in a case that the controller determines that a test result of a cell to be tested is unqualified, indicating that the cell to be tested needs to be replaced, the cell to be tested that needs to be replaced is a cell to be replaced. The controller can deliver a grasp instruction to the gripper component in the replacement device to control the gripper component to grasp the cell to be replaced. The grasp instruction carries the identification information of the cell to be tested with an unqualified test result. One cell to be replaced can be uniquely identified through the identification information.

S10413. The gripper component grasps, in response to the grasp instruction, the cell to be replaced that matches the identification information.

In some embodiments, in response to the grasp instruction delivered by the controller, the gripper component determines, based on the identification information carried in the grasp instruction, the cell to be replaced that needs to be grasped, thereby determining position coordinate information of the cell to be replaced on the module tray. Thus, the cell to be replaced can be removed from the module tray based on the position coordinate information of the cell to be replaced. The removed cell to be replaced can be further placed on the storage mechanism through the gripper component.

In the above embodiment, based on the test result of the cell to be tested, the gripper component is controlled to grasp the cell to be replaced, thereby improving the accuracy and efficiency of grasping the cell to be replaced.

S1042. Control the collection component to collect identification information of a spare cell.

In some embodiments, the spare cell may be a cell that has been tested manually or tested through the testing device and has a qualified test result. Some spare cells can be placed on the storage mechanism in the replacement device. After the cell to be replaced is taken from the module tray, the collection component in the replacement mechanism can be controlled to acquire the identification information of the spare cell.

For example, step S1042 can be implemented through steps S10421 and S10422.

S10421. The collection component sends the identification information of the spare cell to the controller.

In some embodiments, after the collection component acquires the identification information of the spare cell, the collection component can send the identification information to the controller to determine the information of the spare cell used to replace the cell to be replaced.

S10422. The controller binds the identification information of the spare cell with a test result of the spare cell, and uploads the bound identification information and test result to the host computer.

In some embodiments, after receiving the identification information of the spare cell, the controller can bind the previously received data such as the test result of the spare cell with the identification information of the spare cell. The controller uploads both the bound identification information and test result of the spare cell to the host computer, and the host computer stores the received data.

In the above embodiment, since data such as the identification information and test result of the spare cell is bound through the controller, after the spare cell is placed on the module tray and the plurality of cells on the module tray are assembled into a cell module in subsequent processes, it is convenient to trace data such as the test result of the spare cell through the identification information of the spare cell.

S1043. Control the gripper component to grasp the spare cell and place the spare cell at a replacement position, where the replacement position is a position of the cell to be replaced on the module tray.

In some embodiments, after the identification information of the spare cell is acquired, the spare cell is uniquely determined. Then, the gripper component can be controlled to grasp the spare cell, and transport the spare cell to align with the replacement position. After that, the gripper component is controlled to release the spare cell to place the spare cell at the replacement position. The replacement position is a position on the module tray from which the cell to be replaced has been removed.

In the above embodiments, based on the identification information of the cell to be replaced, the gripper component is controlled to grasp the cell to be replaced, thereby improving the accuracy and efficiency of grasping the cell to be replaced. Additionally, the collection component is controlled to acquire the identification information of the spare cell, and the identification information of the spare cell can be bound with data such as the test result of the spare cell, facilitating traceability of the test result of the spare cell. Furthermore, the gripper component is controlled to place the spare cell at the replacement position, improving the speed and accuracy of placing the spare cell, thereby improving the efficiency of replacing the cell to be replaced.

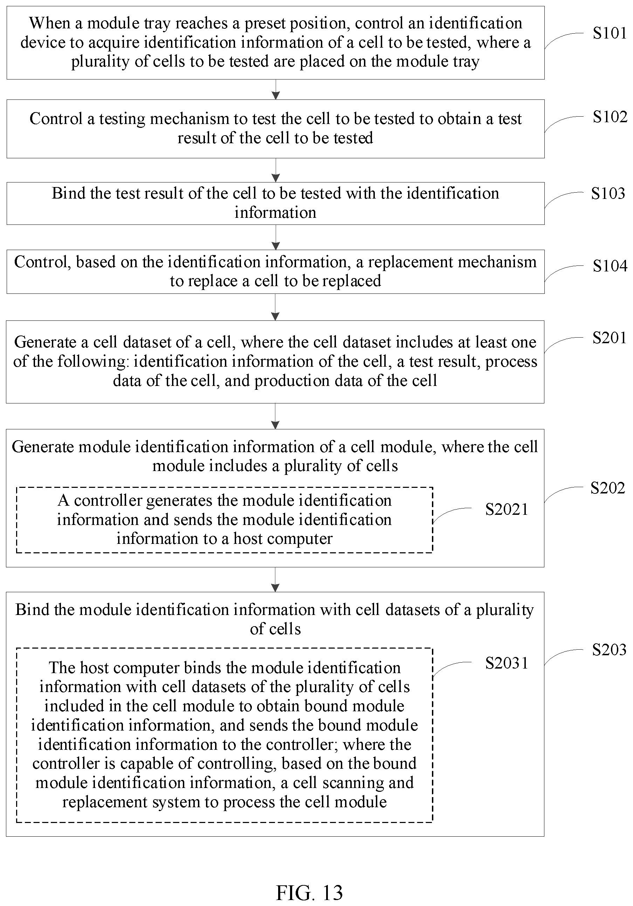

Referring to FIG. 13, FIG. 13 is a fourth schematic flowchart of a control method of a cell scanning and replacement system according to this disclosure. Based on FIG. 10, the method further includes steps S201 to S203.

S201. Generate a cell dataset of a cell, where the cell dataset includes at least one of the following: identification information of the cell, a test result, process data of the cell, and production data of the cell.

In some embodiments, during the cell production process, a large amount of data is generated, such as process data, production data, and test data including a test result of the cell. The process data may include various dimensional data, material data, and the like of the cell. The production data may include data of all production steps that the cell has undergone, and the like. After the identification information of the cell to be tested is acquired, not only the test result can be bound with the identification information, but also the process data and production data of the cell to be tested can be bound with the identification information.

For example, data such as all test results, process data, and production data of the cell can be stored at a data storage location, the identification information can be stored at an identification storage location, and the identification information of the cell can be bound with other data of the cell to establish an association between the identification information and other data. In this way, only the identification information needs to be transmitted at different production stations, reducing the amount of data transmitted. When it is necessary to trace and view some data of a cell, data of the cell can be retrieved simply through the identification information.

S202. Generate module identification information of a cell module, where the cell module includes a plurality of cells.

In some embodiments, after the testing of all cells on a module tray is completed, the cells on the module tray can be assembled into a cell module including a plurality of cells. In this case, module identification information can be generated for each cell module, where the module identification information is used to uniquely identify a cell module.

For example, as shown in FIG. 13, step S202 can be implemented through step S2021.

S2021. The controller generates the module identification information and sends the module identification information to the host computer.

In some embodiments, a controller connected to the devices in the cell scanning and replacement system can generate a piece of module identification information for each cell module. After the controller generates the module identification information, the controller can send the generated module identification information to the host computer, and the host computer receives and stores the module identification information.

S203. Bind the module identification information with cell datasets of the plurality of cells.

In some embodiments, the cell datasets of all cells included in the cell module can be bound with the module identification information of the cell module.

For example, as shown in FIG. 13, step S203 can be implemented through step S2031.

S2031. The host computer binds the module identification information with cell datasets of the plurality of cells included in the cell module to obtain bound module identification information, and sends the bound module identification information to the controller; and the controller is capable of controlling, based on the bound module identification information, the cell scanning and replacement system to process the cell module.

In some embodiments, after the host computer receives the module identification information of the cell module, the host computer can complete the binding of the cell datasets of a plurality of cells already stored in the host computer with the module identification information, and store the bound cell datasets and the obtained bound module identification information in the host computer. The host computer can send the bound module identification information to the controller.

In this way, the module identification information is associated with the cell datasets of all cells in the cell module. The cell datasets of all cells in the cell module can be acquired through the module identification information. During transmission of data of the cell module between various production stations, only the bound module identification information needs to be transmitted, that is, the controller can control, based on the bound module identification information, the devices in the cell scanning and replacement system to process the cell module, thereby reducing the amount of data transmitted and improving the data transmission efficiency.

In the above embodiment, since the cell dataset of the cell is generated based on the identification information, test result, process data, production data, and the like of the cell, the cell dataset of the cell can be acquired through the identification information, facilitating traceability of all data of the cell. Additionally, the module identification information of the cell module including a plurality of cells is generated, and the module identification information is bound with the cell datasets of a plurality of cells, so that the cell datasets of all cells in the cell module can be acquired through the module identification information, facilitating traceability of all data of each cell module.

The above embodiments are merely intended for describing the technical solutions of this disclosure but not for limiting this disclosure. Although this disclosure is described in detail with reference to the foregoing embodiments, persons of ordinary skill in the art should appreciate that they can still make modifications to the technical solutions described in the embodiments or make equivalent replacements to some or all technical features thereof without departing from the scope of the technical solutions of the embodiments of this disclosure. All such modifications and equivalent replacements shall fall within the scope of claims and specification of this disclosure. In particular, as long as there is no structural conflict, the technical features mentioned in the embodiments can be combined in any manner.

## Claims

1. A cell scanning and replacement system, wherein the cell scanning and replacement system comprises:
a testing device, the testing device comprising a testing mechanism, wherein the testing mechanism is configured to test a cell;
an identification device, the identification device being connected to the testing device, wherein the identification device is configured to acquire identification information of the cell, wherein the identification information is associated with a test result of the cell; and
a replacement device, the replacement device being connected to the testing device, and the replacement device comprising a replacement mechanism, wherein the replacement mechanism is electrically connected to the identification device, and the replacement mechanism is configured to replace a cell to be replaced based on the identification information; wherein
the testing device further comprises a testing bracket and a testing longitudinal drive mechanism, wherein the testing longitudinal drive mechanism is movably disposed on the testing bracket along a first direction, the testing mechanism and the identification device are both mounted on the testing longitudinal drive mechanism; and under the drive of the testing longitudinal drive mechanism, the testing mechanism and the identification device are both capable of moving along the first direction; and
the identification device comprises an identification component and an identification vertical drive component, wherein the identification component is mounted on the identification vertical drive component and is configured to acquire the identification information; and the identification vertical drive component is mounted on the testing longitudinal drive mechanism, and the identification vertical drive component is configured to drive the identification component to move along a third direction toward or away from the cell, the third direction forming an angle with the first direction.

2. The cell scanning and replacement system according to claim 1, wherein the testing mechanism comprises a testing component and a testing vertical drive component, wherein the testing component is mounted on the testing vertical drive component and is configured to test a cell; and the testing vertical drive component is mounted on the testing longitudinal drive mechanism, and the testing vertical drive component is configured to drive the testing component to move along the third direction toward or away from the cell, bringing the testing component into contact with or separation from the cell, the third direction forming an angle with the first direction.

3. The cell scanning and replacement system according to claim 2, wherein the testing vertical drive component comprises a vertical power component, a vertical assistance component, and a vertical guide component, wherein the vertical guide component has one end mounted on the testing longitudinal drive mechanism and another end connected to the testing component, and is configured to guide the testing component to move along the third direction; the vertical power component has one end connected to the testing longitudinal drive mechanism and another end connected to the testing component, and is configured to drive the testing component to move along the third direction; and the vertical assistance component has one end connected to the testing longitudinal drive mechanism and another end connected to the testing component, and under the action of the vertical assistance component, the testing component has a tendency to move along the third direction toward the testing longitudinal drive mechanism.

4. The cell scanning and replacement system according to claim 2 or 3, wherein the testing mechanism further comprises a testing transverse drive component, wherein one end of the testing transverse drive component is mounted on the testing vertical drive component, the testing component is connected to the testing transverse drive component, and the testing transverse drive component is configured to drive the testing component to move along a second direction, the second direction forming an angle with each of the first direction and the third direction.

5. The cell scanning and replacement system according to claim 4, wherein the testing mechanism further comprises a testing longitudinal drive component, and the testing component comprises a first testing piece and a second testing piece, wherein the first testing piece is fixedly disposed on the testing transverse drive component; the second testing piece is slidably disposed on the testing transverse drive component; and the testing longitudinal drive component has one end connected to the testing transverse drive component and another end connected to the second testing piece, and the testing longitudinal drive component is configured to drive the second testing piece to move along the first direction toward or away from the first testing piece.

6. The cell scanning and replacement system according to any one of claims 1 to 5, wherein the testing device further comprises a testing lifting mechanism, and the testing lifting mechanism comprises a testing lifting bracket, a testing lifting guide component, a testing lifting drive component, and a testing lifting limit component, wherein the testing lifting guide component has one end connected to the testing bracket and another end connected to the testing lifting bracket, the testing lifting guide component is configured to guide the testing lifting bracket to move along the third direction, and the testing lifting bracket is configured to support a module tray; the testing lifting drive component has one end connected to the testing lifting guide component and another end connected to the testing lifting bracket, and the testing lifting drive component is configured to drive the testing lifting bracket to move along the third direction; and the testing lifting limit component is mounted on the testing bracket and is configured to restrict a position of the module tray with respect to the testing bracket.

7. The cell scanning and replacement system according to any one of claims 1 to 6, wherein the replacement device further comprises a replacement bracket and a replacement longitudinal drive mechanism, wherein the replacement longitudinal drive mechanism is movably disposed on the replacement bracket along the first direction, the replacement mechanism is connected to the replacement longitudinal drive mechanism, and the replacement longitudinal drive mechanism is configured to drive the replacement mechanism to move along the first direction with respect to the replacement bracket.

8. The cell scanning and replacement system according to claim 7, wherein the replacement device further comprises a replacement transverse drive component, wherein the replacement transverse drive component is mounted on the replacement longitudinal drive mechanism, the replacement mechanism is connected to the replacement transverse drive component, and the replacement transverse drive component is configured to drive the replacement mechanism to move along the second direction.

9. The cell scanning and replacement system according to claim 8, wherein the replacement device further comprises a replacement vertical drive component, wherein the replacement vertical drive component is mounted on the replacement transverse drive component, the replacement mechanism is mounted on the replacement vertical drive component, and the replacement vertical drive component is configured to drive the replacement mechanism to move along the third direction.

10. The cell scanning and replacement system according to claim 7 or 8, wherein the replacement mechanism comprises a collection component and a gripper component, wherein the collection component is configured to acquire identification information of a spare cell; and the gripper component is configured to grasp or release a cell.

11. The cell scanning and replacement system according to claim 7 or 8, wherein the replacement device further comprises a storage mechanism, the storage mechanism comprising a storage bracket, a storage tray, and a storage guide component, wherein the storage bracket is mounted on the replacement bracket; the storage guide component is mounted on the storage bracket and extends along the second direction; and the storage tray is mounted on the storage guide component, and the storage tray is capable of moving along the second direction through the storage guide component.

12. The cell scanning and replacement system according to claim 11, wherein the storage tray comprises a positioning piece, a clamping piece, and a clamping drive component, wherein the positioning piece is mounted on the storage guide component; and the clamping drive component has one end connected to the storage guide component and another end connected to the clamping piece, and the clamping drive component is configured to drive the clamping piece to move along a direction toward or away from the positioning piece to clamp or release a cell.

13. The cell scanning and replacement system according to claim 7, wherein the replacement device further comprises a replacement lifting mechanism, the replacement lifting mechanism comprising a replacement lifting bracket, a replacement lifting component, and a release component, wherein the replacement lifting component has one end connected to the replacement bracket and another end connected to the replacement lifting bracket, the replacement lifting component is configured to drive the replacement lifting bracket to move along the third direction, and the replacement lifting bracket is configured to support a module tray; and the release component is mounted on the replacement lifting bracket and is configured to drive a tray clamping piece on the module tray to move, causing the module tray to release the clamping of a cell.

14. A battery production line, comprising:
a cell assembly system, wherein the cell assembly system is configured to assemble a cell to obtain the cell to be tested;
the cell scanning and replacement system according to any one of claims 1 to 13; and
a storage system, wherein the storage system is configured to store a cell that has completed all test items.

15. A control method of a cell scanning and replacement system, wherein the cell scanning and replacement system comprises a host computer, a controller, an identification device, a testing device, and a replacement device, the testing device comprising a testing mechanism, and the replacement device comprising a replacement mechanism; and the control method of a cell scanning and replacement system comprises:
when a module tray reaches a preset position, controlling the identification device to acquire identification information of a cell to be tested; wherein a plurality of cells to be tested are placed on the module tray;
controlling the testing mechanism to test the cell to be tested to obtain a test result of the cell to be tested;
binding the test result of the cell to be tested with the identification information;
controlling, based on the identification information, the replacement mechanism to replace a cell to be replaced;
generating a cell dataset of a cell, wherein the cell dataset comprises at least one of the following: identification information of the cell, a test result, process data of the cell, and production data of the cell;
generating module identification information of a cell module, wherein the cell module comprises a plurality of cells; and
binding the module identification information with cell datasets of the plurality of cells.

16. The control method of a cell scanning and replacement system according to claim 15, wherein the binding the test result of the cell to be tested with the identification information comprises:
sending, by the testing mechanism, the test result of the cell to be tested to the controller; and
binding, by the controller, the identification information of the cell to be tested with the test result of the cell to be tested, and uploading the bound identification information and test result to the host computer.

17. The control method of a cell scanning and replacement system according to claim 15 or 16, wherein the replacement mechanism comprises a collection component and a gripper component; and the controlling the replacement mechanism to replace a cell to be replaced comprises:
controlling, based on identification information of the cell to be replaced, the gripper component to grasp the cell to be replaced;
controlling the collection component to collect identification information of a spare cell; and
controlling the gripper component to grasp the spare cell and place the spare cell at a replacement position, wherein the replacement position is a position of the cell to be replaced on the module tray.

18. The control method of a cell scanning and replacement system according to claim 17, wherein the controlling the gripper component to grasp the cell to be replaced comprises:
sending, by the testing mechanism, the test result of the cell to be tested to the controller;
in a case that the controller determines that the test result is unqualified, delivering, by the controller, a grasp instruction to the gripper component, wherein the grasp instruction carries identification information of the cell to be replaced that matches the unqualified test result; and
grasping, by the gripper component in response to the grasp instruction, the cell to be replaced that matches the identification information.

19. The control method of a cell scanning and replacement system according to claim 17 or 18, wherein the controlling the collection component to collect identification information of a spare cell comprises:
sending, by the collection component, the identification information of the spare cell to the controller; and
binding, by the controller the identification information of the spare cell with a test result of the spare cell, and uploading the bound identification information and test result to the host computer.

20. The control method of a cell scanning and replacement system according to any one of claims 15 to 19, wherein the generating module identification information of a cell module comprises:
generating, by the controller, the module identification information, and sending the module identification information to the host computer; and
the binding the module identification information with cell datasets of the plurality of cells comprises:
binding, by the host computer, the module identification information with cell datasets of the plurality of cells comprised in the cell module to obtain bound module identification information, and sending the bound module identification information to the controller; wherein the controller is capable of controlling, based on the bound module identification information, the cell scanning and replacement system to process the cell module.
